# EUROPEAN PATENT APPLICATION

(11) **EP 4 395 519 A1**
(43) Date of publication of application: **03.07.2024**
(21) Application number: 23218460.6
(22) Date of filing: 20.12.2023
(51) Int. Cl.: H10K 85/30, H10K 85/60, H10K 50/11

(54) **ORGANIC LIGHT EMITTING DEVICE COMPRISING ORGANOMETALLIC COMPOUND AND PLURALITY OF HOST MATERIALS**

(30) Priority: 28.12.2022 KR 20220188039
(71) Applicant: LG Display Co., Ltd., Seoul 07336 (KR)
(72) Inventor: Park, Hansol, 10845 Paju-si (KR); Yoo, Misang, 10845 Paju-si (KR); Jeong, Yoojeong, 10845 Paju-si (KR); Choung, Kusun, 10845 Paju-si (KR)
(74) Representative: Cousens, Nico

(57) **Abstract**

An organic light-emitting diode including: a first electrode; a second electrode facing the first electrode; and an organic layer disposed between the first electrode and the second electrode. The organic layer includes a light-emitting layer that includes a dopant material including an organometallic compound represented by Chemical Formula 1, and a host material including a mixture including a compound represented by Chemical Formula 2 and a compound represented by Chemical Formula 3. The organic light-emitting diode may have excellent or desirable light-emitting efficiency and lifespan.

## Description

### BACKGROUND

### 1. Technical Field

The present disclosure relates to an organic light-emitting diode including an organometallic compound and a plurality of host materials.

### 2. Description of the Related Art

Display devices are ubiquitous, and interest in such devices is increasing. One of the display devices is an organic light-emitting display device including an organic light-emitting diode (OLED) which is rapidly developing.

In the organic light-emitting diode, when electric charges are injected into a light-emitting layer formed or disposed between a positive electrode and a negative electrode, an electron and a hole may be recombined with each other in the light-emitting layer to form an exciton. The energy of the exciton may be converted to light that will be emitted by the organic light-emitting diode. Compared to conventional display devices, the organic light-emitting diode may operate at a lower voltage, consume relatively little power, render excellent colors, and may be used in a variety of ways when the organic light-emitting diode includes a flexible substrate. Further, a size of the organic light-emitting diode may be adjustable.

The organic light-emitting diode (OLED) may have superior viewing angle and contrast ratio compared to a liquid crystal display (LCD), and may be lightweight and ultrathin because the OLED may not require a backlight. The organic light-emitting diode may include a plurality of organic layers between a negative electrode (electron injection electrode; cathode) and a positive electrode (hole injection electrode; anode). The plurality of organic layers may include a hole injection layer, a hole transport layer, a hole transport auxiliary layer, an electron blocking layer, and a light-emitting layer, an electron transport layer, etc.

In this organic light-emitting diode structure, when a voltage is applied across the two electrodes, electrons and holes are injected from the negative and positive electrodes, respectively, into the light-emitting layer. Excitons are generated in the light-emitting layer and then fall to a ground state to emit light.

Organic materials used in the organic light-emitting diode may be largely classified into light-emitting materials and charge-transporting materials. The light-emitting material may be an important factor in determining luminous efficiency of the organic light-emitting diode. The luminescent material may have high quantum efficiency, excellent electron and hole mobility, and may exist uniformly and stably in the light-emitting layer. The light-emitting materials may be classified into light-emitting materials emitting blue, red, and green colors based on colors of the light. A color-generating material may include a host and dopants to increase the color purity and luminous efficiency through energy transfer.

When a fluorescent material is used, singlets, which make up about 25% of excitons generated in the light-emitting layer, are used to emit light, while most of triplets, which make up 75% of the excitons generated in the light-emitting layer, are dissipated as heat. However, when a phosphorescent material is used, both singlets and triplets may emit light.

Conventionally, an organometallic compound may be used as the phosphorescent material in the organic light-emitting diode. The performance of an organic light-emitting diode may be improved by deriving a high-efficiency phosphorescent dopant material and applying a host material that may have optimal or desirable photophysical properties. The diode efficiency and lifetime may be improved compared to a conventional organic light-emitting diode.

### SUMMARY

Accordingly, an object of the present disclosure is to provide an organic light-emitting diode in which an organic light-emitting layer contains an organometallic compound and a plurality of host materials capable of lowering operation voltage, and improving efficiency, and lifespan.

Objects of the present disclosure are not limited to the above-mentioned objects. Other objects and advantages of the present disclosure that are not mentioned may be understood based on following description, and may be more clearly understood based on aspects of the present disclosure. Further, it may be easily understood that the objects and advantages of the present disclosure may be realized using means shown in the claims and combinations thereof.

To achieve these and other advantages and in accordance with objects of the disclosure, as embodied and broadly described herein, an organic light-emitting diode includes: a first electrode; a second electrode facing the first electrode; and an organic layer disposed between the first electrode and the second electrode, the organic layer including a light-emitting layer that includes a dopant material including an organometallic compound represented by Chemical Formula 1, and a host material including a mixture including a compound represented by Chemical Formula 2 and a compound represented by Chemical Formula 3: 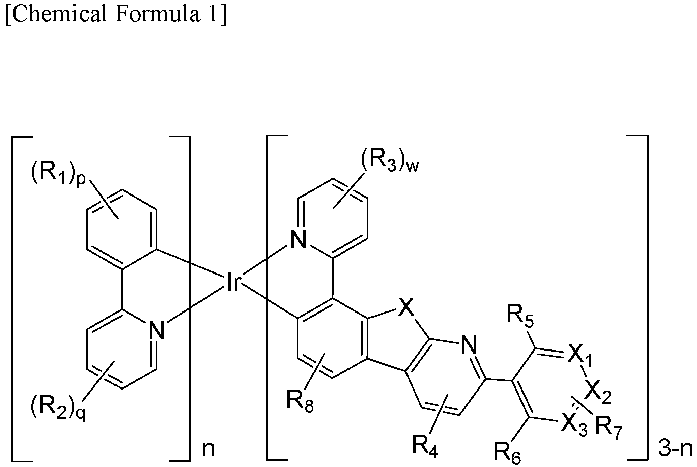 wherein in the Chemical Formula 1,
X may represent one selected from the group consisting of oxygen (O), sulfur (S), and selenium (Se),
each of X₁, X₂, and X₃ may independently represent nitrogen (N) or CR',
each of R₁, R₂, R₃, R₄, R₇, R₈, and R' may independently represent one selected from the group consisting of hydrogen, deuterium, halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₁, R₂, R₃, R₄, R₇, R₈, and R' is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₁, R₂, R₃, R₄, R₇, R₈, and R' may be substituted by deuterium,
wherein each of R₅ and R₆ may independently represent one selected from the group consisting of halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₅ and R₆ is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₅ and R₆ may be substituted by deuterium,
n is an integer from 0 to 2, and
p, q and w may independently be an integer from 1 to 4,

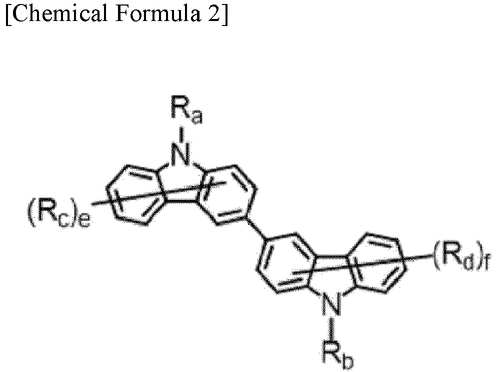

   wherein in the Chemical Formula 2,
   each of Rₐ and R_{b} may independently represent one selected from the group consisting of a C6 to C40 monocyclic aryl group, a polycyclic aryl group, a monocyclic heteroaryl group, and a polycyclic heteroaryl group, where each of Rₐ and R_{b} may independently be substituted with at least one substituent selected from the group consisting of an alkyl group, an aryl group, a heteroaryl group, a cyano group, an alkylsilyl group, and an arylsilyl group,
   each of R_{c} and R_{d} may independently represent one selected from the group consisting of hydrogen, deuterium, halogen, a cyano group, and an alkyl group, wherein each of e and f may independently represent an integer from 0 to 7, when e is 2, 3, 4, 5, 6 or 7, each R_{c} is the same as or different from each other, when f is 2, 3, 4, 5, 6 or 7, each R_{d} is the same as or different from each other, 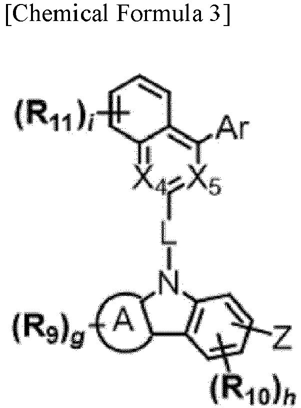 wherein in the Chemical Formula 3,
      a ring A may be a monocyclic or polycyclic aryl group,
      each of X₄ and X₅ may independently represent N or CR₁₂;
      L may represent one selected from the group consisting of a single bond, a C1 to C10 alkylene group, a C6 to C30 arylene group, a C2 to C30 heteroarylene group, and a C5 to C30 cycloalkylene group,
      Ar may represent one selected from the group consisting of hydrogen, deuterium, halogen, a C1 to C30 alkyl group, a C6 to C30 aryl group, and a C2 to C30 heteroaryl group;
      Z may independently represent one selected from the group consisting of compounds of following structures: 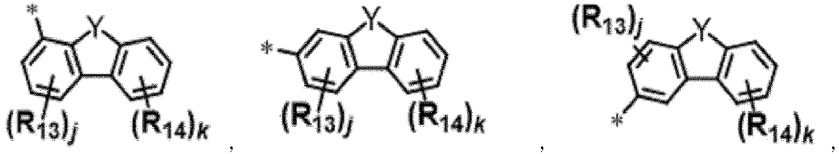 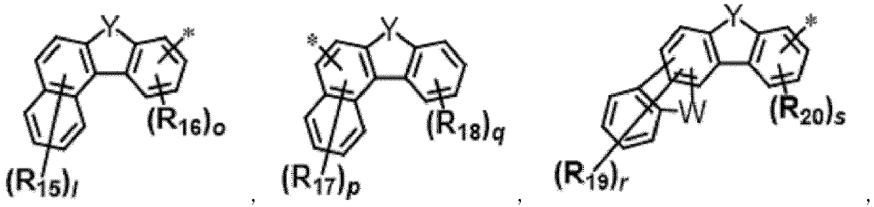 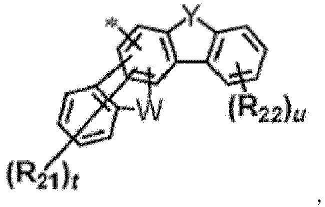 where each of Y and W may independently represent one selected from the group consisting of O, S, C(R₂₃)₂, and NR₂₄,
         each of R₉ to R₂₄ may independently represent one selected from the group consisting of hydrogen, deuterium, halogen, hydroxyl group, a cyano group, a nitro group, an amidino group, a C 1 to C10 alkyl group, a C3 to C20 cycloalkyl group, a C 1 to C20 heteroalkyl group, a C7 to C20 arylalkyl group, a C6 to C30 aryl group, and a C2 to C30 heteroaryl group,
         each of i, k, q, and u may independently be an integer from 1 to 4, each of h, j, o, and s may independently be an integer from 1 to 3, each of g, and 1 may independently be an integer from 1 to 6, r may be an integer from 1 to 6, and each of p and t may independently be an integer from 1 to 5.

In some embodiments, in the Chemical Formula 1, n may be 2.

In some embodiments, X in the Chemical Formula 1 may be oxygen (O).

In some embodiments, the organometallic compound represented by the Chemical Formula 1 may include one selected from the group consisting of compound GD-1 to compound GD-10.

In some embodiments, each of Rₐ and R_{b} in the Chemical Formula 2 may independently represent one selected from the group consisting of a phenyl group, a naphthyl group, an anthryl group, a chrysenyl group, a pyrenyl group, a phenanthryl group, a triphenylenyl group, a fluorenyl group, and a 9,9'-spirofluorenyl group.

In some embodiments, the compound represented by the Chemical Formula 2 may include one selected from the group consisting of compound GHH-1 to compound GHH-20.

In some embodiments, each of X₄ and X₅ in the Chemical Formula 3 may independently represent N.

In some embodiments, each of R₉ to R₂₄ in the Chemical Formula 3 may independently represent one selected from the group consisting of hydrogen, deuterium, a C1 to C10 alkyl group, a C7 to C20 arylalkyl group, a C6 to C30 aryl group, and a C2 to C30 heteroaryl group.

In some embodiments, the compound represented by the Chemical Formula 3 may include one selected from the group consisting of compound GEH-1 to compound GEH-20.

In some embodiments, the organic layer may further include at least one selected from the group consisting of a hole injection layer, a hole transport layer, an electron transport layer, and an electron injection layer.

According to another aspect of the present disclosure, an organic light-emitting diode includes: a first electrode; a second electrode facing the first electrode; a first light-emitting stack; and a second light-emitting stack, wherein the first and second light-emitting stacks are disposed between the first electrode and the second electrode, wherein each of the first light-emitting stack and the second light-emitting stack includes at least one light-emitting layer including a green phosphorescent light-emitting layer including: a dopant material including an organometallic compound represented by Chemical Formula 1, and a host material including a mixture including a compound represented by Chemical Formula 2 and a compound represented by Chemical Formula 3.

In some embodiments, the organometallic compound represented by the Chemical Formula 1 may include one selected from the group consisting of compound GD-1 to compound GD-10.

In some embodiments, the compound represented by the Chemical Formula 2 may include one selected from the group consisting of compound GHH-1 to compound GHH-20.

In some embodiments, the compound represented by the Chemical Formula 3 may include one selected from the group consisting of compound GEH-1 to compound GEH-20.

According to another aspect of the present disclosure, an organic light-emitting diode includes: a first electrode; a second electrode facing the first electrode; a first light-emitting stack; a second light-emitting stack; and a third light-emitting stack, wherein the first, second, and third light-emitting stacks are disposed between the first electrode and the second electrode, wherein each of the first light-emitting stack, the second light-emitting stack, and the third light-emitting stack includes at least one light-emitting layer that includes a green phosphorescent light-emitting layer that includes: a dopant material including an organometallic compound represented by Chemical Formula 1, and a host material including a mixture including a compound represented by Chemical Formula 2 and a compound represented by Chemical Formula 3.

In some embodiments, the organometallic compound represented by the Chemical Formula 1 may include one selected from the group consisting of compound GD-1 to compound GD-10.

In some embodiments, the compound represented by the Chemical Formula 2 may include one selected from the group consisting of compound GHH-1 to compound GHH-20.

In some embodiments, the compound represented by the Chemical Formula 3 may include one selected from the group consisting of compound GEH-1 to compound GEH-20.

According to another aspect of the present disclosure, an organic light-emitting display device includes: a substrate; a driving element disposed on the substrate; and an organic light-emitting diode disposed on the substrate and connected to the driving element, wherein the organic light-emitting diode includes the organic light-emitting diode as disclosed herein.

In the organic light-emitting diode according to the present disclosure, the organometallic compound represented by the Chemical Formula 1 may be used as a phosphorescent dopant, and the compound represented by the Chemical Formula 2 and the compound represented by the Chemical Formula 3 are mixed with each other to produce a mixture which may be used as a phosphorescent host. Thus, the operation voltage of the organic light-emitting diode may be lowered and the efficiency, and lifetime characteristics thereof may be improved. Thus, low power consumption may be achieved.

Effects of the present disclosure are not limited to the above-mentioned effects, and other effects not mentioned may be clearly understood by those skilled in the art from following description.

It is to be understood that both the foregoing general description and the following detailed description of the present disclosure are merely by way of example and are intended to provide further explanation of the inventive concepts as claimed.

### BRIEF DESCRIPTION OF DRAWINGS

FIG. 1 is a schematic cross-sectional view of an organic light-emitting diode according to an embodiment of the present disclosure.
FIG. 2 is a schematic cross-sectional view of an organic light-emitting diode having a tandem structure including two light-emitting stacks according to an embodiment of the present disclosure.
FIG. 3 is a cross-sectional view schematically showing an organic light-emitting diode of a tandem structure having three light-emitting stacks according to an embodiment of the present disclosure.
FIG. 4 is a cross-sectional view schematically illustrating an organic light-emitting display device including an organic light-emitting diode according to an illustrative embodiment of the present disclosure.

### DETAILED DESCRIPTION

Reference will now be made in detail to some of the examples and embodiments of the disclosure illustrated in the accompanying drawings. Wherever possible, the same reference numbers will be used throughout the drawings to refer to the same or like parts.

Advantages and features of the present disclosure, and a method of achieving the advantages and features will become apparent with reference to the example embodiments described herein in detail together with the accompanying drawings. The present disclosure should not be construed as limited to the example embodiments as disclosed below, and may be embodied in various different forms. Thus, these example embodiments are set forth to make the present disclosure sufficiently complete, and to assist those skilled in the art to fully understand the scope of the present disclosure. The protected scope of the present disclosure is defined by claims and their equivalents.

For convenience of description, a scale in which each of elements is illustrated in the accompanying drawings may differ from an actual scale. Thus, the illustrated elements are not limited to the specific scale in which they are illustrated in the drawings. The same reference numbers in different drawings represent the same or similar elements, which may perform similar functionality. Further, where the detailed description of the relevant known steps and elements may obscure an important point of the present disclosure, a detailed description of such known steps and elements may be omitted. Furthermore, in the following detailed description of the present disclosure, numerous specific details are set forth to provide a sufficiently thorough understanding of the present disclosure. However, it will be understood that the present disclosure may be practiced without these specific details. In other instances, known methods, procedures, components, and circuits have not been described in detail so as not to unnecessarily obscure aspects of the present disclosure.

Although example embodiments of the present disclosure are described in detail with reference to the accompanying drawings, the present disclosure is not limited thereto.

Therefore, example embodiments of the present disclosure are provided for illustrative purposes only and are not intended to limit the technical concept of the present disclosure. The scope of the technical concept of the present disclosure is not limited thereto. Therefore, it should be understood that the above-described example embodiments are illustrative in all aspects and do not limit the present disclosure. The protective scope of the present disclosure should be construed based on the following claims, and all the technical concepts in the equivalent scope thereof should be construed as falling within the scope of the present disclosure.

The shapes, sizes, ratios, angles, numbers, and the like, which are illustrated in the drawings to describe various example embodiments of the present disclosure, are merely given by way of example. Therefore, the present disclosure is not limited to the illustrations in the drawings. The same or similar elements are designated by the same reference numerals throughout the specification unless otherwise specified.

The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise.

In the present specification, where the terms "comprise," "have," "include," and the like are used, one or more other elements may be added unless the term, such as "only," is used. As used herein, the term "and/or" includes a single associated listed item and any and all of the combinations of two or more of the associated listed items. An expression such as "at least one of' when preceding a list of elements may modify the entire list of elements and may not modify the individual elements of the list. The term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

In construing an element or numerical value, the element or the numerical value is to be construed as including an error or tolerance range even where no explicit description of such an error or tolerance range is provided.

It will be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly connected to or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present. In the description of the various embodiments of the present disclosure, where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used.

Further, as used herein, when a layer, film, region, plate, or the like may be disposed "on" or "on a top" of another layer, film, region, plate, or the like, the former may directly contact the latter or another layer, film, region, plate, or the like may be disposed between the former and the latter. As used herein, when a layer, film, region, plate, or the like is directly disposed "on" or "on a top" of another layer, film, region, plate, or the like, the former directly contacts the latter and another layer, film, region, plate, or the like is not disposed between the former and the latter. Further, as used herein, when a layer, film, region, plate, or the like may be disposed "below" or "under" another layer, film, region, plate, or the like, the former may directly contact the latter or another layer, film, region, plate, or the like may be disposed between the former and the latter. As used herein, when a layer, film, region, plate, or the like is directly disposed "below" or "under" another layer, film, region, plate, or the like, the former directly contacts the latter and another layer, film, region, plate, or the like is not disposed between the former and the latter.

In descriptions of temporal relationships, for example, temporal precedent relationships between two events such as "after", "subsequent to", "before", "next," etc., another event may occur therebetween unless a more limiting term, "just," "immediate(ly)," or "direct(ly)" ("directly after", "directly subsequent", "directly before") is indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

The features of the various embodiments of the present disclosure may be partially or overall combined with each other, and may be variously inter-operated with each other and driven technically as those skilled in the art can sufficiently understand. The embodiments may be implemented independently of each other and may be implemented together in an co-dependent relationship.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects," and the like should not be construed such that any aspect or design as described is superior to or advantageous over other aspects or designs.

Further, the term "or" means "inclusive or" rather than "exclusive or". That is, unless otherwise stated or clear from the context, the expression that "x uses a or b" means any one of natural inclusive permutations.

The terms used in the description below may be general and universal in the relevant art. However, there may be other terms depending on the development and/or change of technology, convention, preference of technicians, etc. Therefore, the terms used in the description below should not be understood as limiting the disclosure, and should be understood as examples of the terms for describing embodiments.

Further, in some example embodiments, a term may be arbitrarily selected by the applicant, and in this case, the detailed meaning thereof will be described in a corresponding description section. Therefore, such terms used in the description below may be understood based on the name of the terms, and the meaning of the terms and the contents throughout the Detailed Description.

As used herein, the term "halo" or "halogen" includes fluorine, chlorine, bromine, and iodine.

As used herein, the term "alkyl group" refers to both linear alkyl radicals and branched alkyl radicals. Unless otherwise specified, the alkyl group contains 1 to 20 carbon atoms, and includes methyl, ethyl, propyl, isopropyl, butyl, isobutyl, tert-butyl, etc. Further, the alkyl group may be optionally substituted.

As used herein, the term "cycloalkyl group" refers to a cyclic alkyl radical. Unless otherwise specified, the cycloalkyl group contains 3 to 20 carbon atoms, and includes cyclopropyl, cyclopentyl, cyclohexyl, and the like. Further, the cycloalkyl group may be optionally substituted.

As used herein, the term "alkenyl group" refers to both linear alkene radicals and branched alkene radicals. Unless otherwise specified, the alkenyl group contains 2 to 20 carbon atoms. Additionally, the alkenyl group may be optionally substituted.

As used herein, the term "cycloalkenyl group" refers to a cyclic alkenyl radical. Unless otherwise specified, the cycloalkenyl group contains 3 to 20 carbon atoms. Additionally, the cycloalkenyl group may be optionally substituted.

As used herein, the term "alkynyl group" refers to both linear alkyne radicals and branched alkyne radicals. Unless otherwise specified, the alkynyl group contains 2 to 20 carbon atoms. Additionally, the alkynyl group may be optionally substituted.

The terms "aralkyl group" and "arylalkyl group" as used herein are used interchangeably with each other and refer to an alkyl group having an aromatic group as a substituent. Further, the arylalkyl group may be optionally substituted.

The terms "aryl group" and "aromatic group" as used herein are used in the same meaning. The aryl group includes both a monocyclic group and a polycyclic group. The polycyclic group may include a "fused ring" in which two or more rings are fused with each other such that two carbons are common to two adjacent rings. Unless otherwise specified, the aryl group contains 6 to 60 carbon atoms. Further, the aryl group may be optionally substituted.

The term "heterocyclic group" as used herein means that at least one of carbon atoms constituting an aryl group, a cycloalkyl group, or an aralkyl group (arylalkyl group) is substituted by a heteroatom such as oxygen (O), nitrogen (N), sulfur (S), etc. Further, the heterocyclic group may be optionally substituted.

The term "carbon ring" as used herein may be used as a term including both "cycloalkyl group" as an alicyclic group and "aryl group" an aromatic group unless otherwise specified.

The terms "heteroalkyl group" and "heteroalkenyl group" as used herein mean that at least one of carbon atoms constituting an alkyl or an alkenyl group is substituted by a heteroatom such as oxygen (O), nitrogen (N), or sulfur (S). In addition, the heteroalkyl group and the heteroalkenyl group may be optionally substituted.

As used herein, the term "substituted" means that a substituent other than hydrogen (H) binds to corresponding carbon. The substituent for the term "substituted", unless defined otherwise, may include one selected from, for example, deuterium, tritium, a C1-C20 alkyl group unsubstituted or substituted with halogen, a C1-C20 alkoxy group unsubstituted or substituted with halogen, halogen, a carboxy group, an amine group, a C1-C20 alkylamine group, a C6-C30 arylamine group, a C7-C30 alkylarylamine group, a nitro group, a C1-C20 alkylsilyl group, a C1-C20 alkoxysilyl group, a C3-C30 cycloalkylsilyl group, a C6-C30 arylsilyl group, a C6-C30 aryl group, a C2-C30 heteroaryl group and combinations thereof. However, the present disclosure is not limited thereto.

Unless otherwise stated herein, substituents not defined by a number of carbon atoms may contain up to 60 carbon atoms, and the minimum number of carbon atoms that may be included in each substituent is determined by what is known.

Subjects and substituents as defined in the present disclosure may be the same as or different from each other unless otherwise specified.

Hereinafter, example embodiments of the present disclosure will be described in detail with reference to the accompanying drawings. In adding reference numerals to elements of each of the drawings, although the same elements are illustrated in other drawings, like reference numerals may refer to like elements.

Hereinafter, example embodiments of an organometallic compound according to the present disclosure and of an organic light-emitting diode including the same will be described in detail.

Conventionally, an organometallic compound may be used as a dopant in a phosphorescent light-emitting layer. For example, a structure such as 2-phenylpyridine may be known as a main ligand structure of an organometallic compound. However, such a conventional light-emitting dopant has limitations in improving the efficiency and lifetime of the organic light-emitting diode. Thus, it may be necessary to develop a novel light-emitting dopant material. The present disclosure has been completed by experimentally confirming that when a mixture of a hole transport type host and an electron transport type host as host materials is used together with the novel dopant material, the efficiency and lifetime of the organic light-emitting diode may be improved, and an operation voltage may be lowered, thereby improving the characteristics of the organic light-emitting diode.

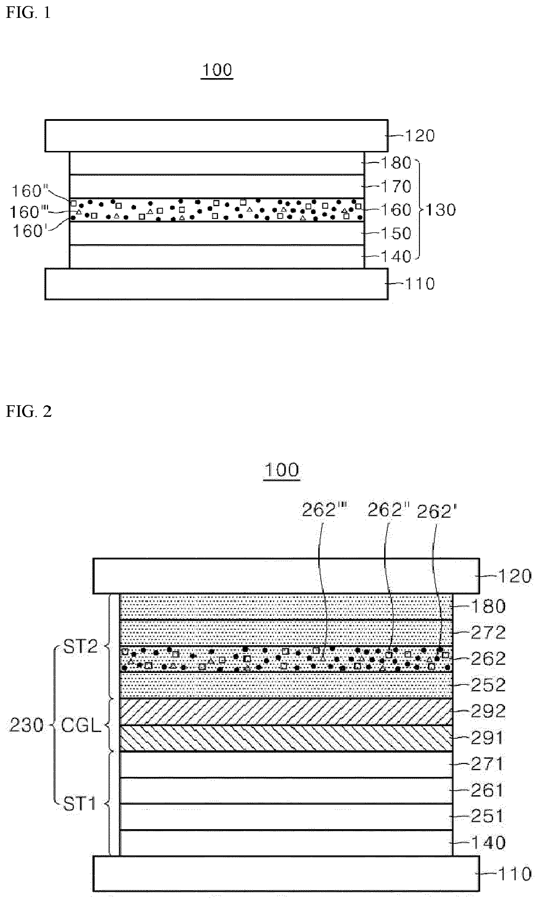

As illustrated in FIG. 1, according to an example embodiment of the present disclosure, an organic light-emitting diode 100 includes a first electrode 110; a second electrode 120 facing the first electrode 110; and an organic layer 130 disposed between the first electrode 110 and the second electrode 120. The organic layer 130 may include a light-emitting layer 160. The light-emitting layer 160 may include a dopant material 160' and host materials 160" and 160‴. The dopant material may include an organometallic compound 160' represented by the following Chemical Formula 1. The host material may include a mixture of two types of host materials: a compound 160" represented by the following Chemical Formula 2 as the hole transporting host material and a compound 160'" represented by the following Chemical Formula 3 as the electron transporting host material: 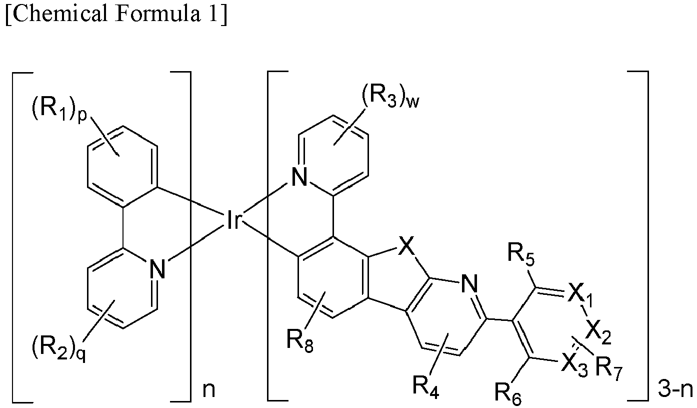 wherein in the Chemical Formula 1,
X may represent one selected from the group consisting of oxygen (O), sulfur (S), and selenium (Se),
each of X₁, X₂, and X₃ may independently represent nitrogen (N) or CR',
each of R₁, R₂, R₃, R₄, R₇, R₈, and R' may independently represent one selected from the group consisting of hydrogen, deuterium, halogen, halide, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, a phosphino group, and combinations thereof, wherein when at least one of R₁, R₂, R₃, R₄, R₇, R₈, and R' is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₁, R₂, R₃, R₄, R₇, R₈, and R' may be substituted by deuterium,
wherein each of R₅ and R₆ may independently represent one selected from the group consisting of halogen, halide, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, a phosphino group, and combinations thereof, wherein when at least one of R₅ and R₆ is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₅ and R₆ may be substituted by deuterium,
n may be an integer from 0 to 2,
p, q and w may independently be an integer from 1 to 4, 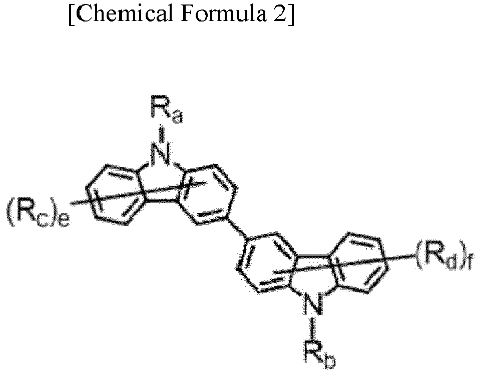 wherein in the Chemical Formula 2,
   each of Rₐ and R_{b} may independently represent one selected from the group consisting of a C6 to C40 monocyclic aryl group, a polycyclic aryl group, a monocyclic heteroaryl group, and a polycyclic heteroaryl group, wherein each of Rₐ and R_{b} may independently be substituted with at least one substituent selected from the group consisting of an alkyl group, an aryl group, a heteroaryl group, a cyano group, an alkylsilyl group, and an arylsilyl group,
   each of R_{c} and R_{d} may independently represent one selected from the group consisting of hydrogen, deuterium, halogen, a cyano group, and an alkyl group, wherein each of e and f may independently represent an integer from 0 to 7, wherein when e is 2, 3, 4, 5, 6 or 7, each R_{c} is the same as or different from each other, wherein when f is 2, 3, 4, 5, 6 or 7, each R_{d} is the same as or different from each other, 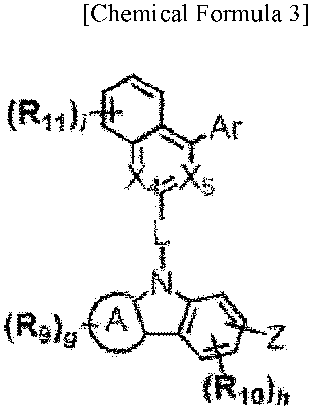 wherein in the Chemical Formula 3,
      a ring A may be a monocyclic or polycyclic aryl group,
      each of X₄ and X₅ may independently represent N or CR₁₂;
      L may represent one selected from the group consisting of a single bond, a C1 to C10 alkylene group, a C6 to C30 arylene group, a C2 to C30 heteroarylene group, and a C5 to C30 cycloalkylene group,
      Ar may represent one selected from the group consisting of hydrogen, deuterium, halogen, a C1 to C30 alkyl group, a C6 to C30 aryl group, and a C2 to C30 heteroaryl group;
      Z may represent one selected from the group consisting of compounds of following structures: 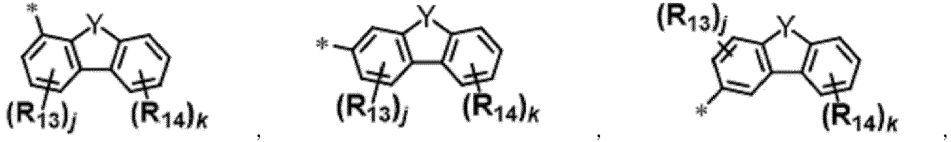 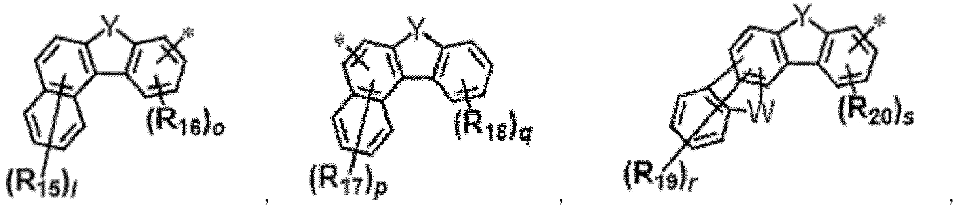 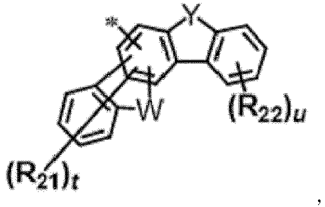 where each of Y and W may independently represent one selected from the group consisting of O, S, C(R₂₃)₂, and NR₂₄,
         each of R₉ to R₂₄ may independently represent one selected from the group consisting of hydrogen, deuterium, halogen, hydroxyl group, a cyano group, a nitro group, an amidino group, a C1 to C10 alkyl group, a C3 to C20 cycloalkyl group, a C1 to C20 heteroalkyl group, a C7 to C20 arylalkyl group, a C6 to C30 aryl group, and a C2 to C30 heteroaryl group,
         each of i, k, q, and u may independently be an integer from 1 to 4, each of h, j, o, and s may independently be an integer from 1 to 3, each of g and 1 may independently be an integer from 1 to 6, r may be an integer from 1 to 6, and each of p and t may independently be an integer from 1 to 5.

The present disclosure may include example embodiments in which none, some or all of hydrogens of at least one of the organometallic compound represented by the Chemical Formula 1, the compound represented by the Chemical Formula 2, and the compound represented by the Chemical Formula 3 are substituted by deuterium.

According to an example embodiment of the present disclosure, the organometallic compound represented by the above Chemical Formula 1 may have a heteroleptic or homoleptic structure. For example, the organometallic compound represented by the above Chemical Formula 1 may have a homoleptic structure where n in the Chemical Formula 1 is 0, a heteroleptic structure in which n in the Chemical Formula 1 is 1, or a heteroleptic structure where n in the Chemical Formula 1 is 2. In an example, n in the Chemical Formula 1 may be 2.

According to an example embodiment of the present disclosure, X in the Chemical Formula 1 may be oxygen (O).

According to an example embodiment of the present disclosure, the organometallic compound represented by the Chemical Formula 1 may include or be one selected from the group consisting of following compound GD-1 to compound GD-10. However, the specific example of the compound represented by the Chemical Formula 1 of the present disclosure is not limited thereto as long as it meets the above definition of the Chemical Formula 1:

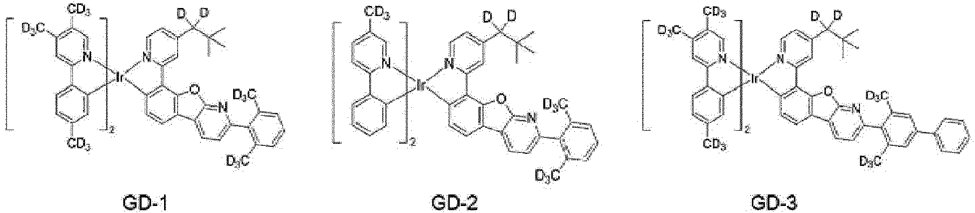

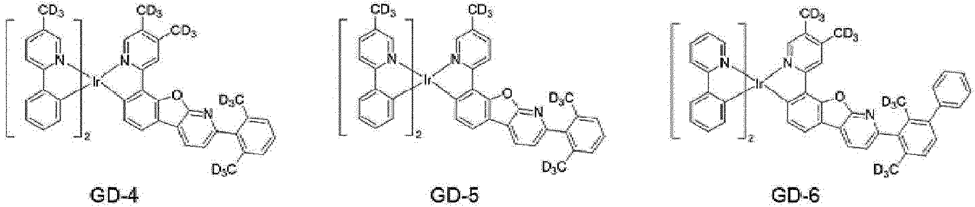

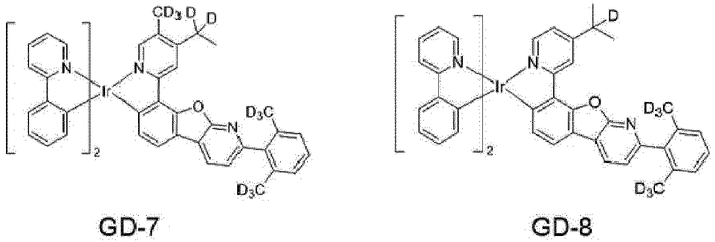

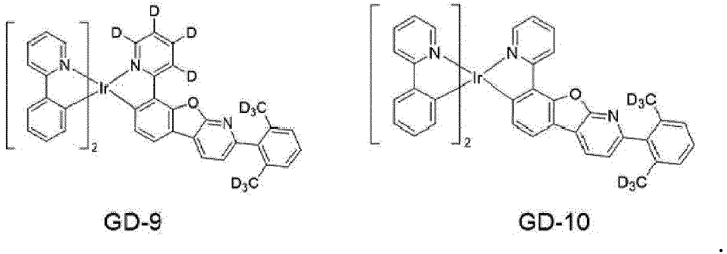

According to an example embodiment of the present disclosure, each of Rₐ and R_{b} in the Chemical Formula 2 may be a C6 to C40 monocyclic or polycyclic aryl group or heteroaryl group. Each of C6 to C40 aryl group as each of Rₐ and R_{b} in the Chemical Formula 2 may independently be substituted with one or more substituents selected from the group consisting of an alkyl group, an aryl group, a cyano group, an alkylsilyl group, and an arylsilyl group.

According to an example embodiment of the present disclosure, each of Rₐ and R_{b} may be a monocyclic or polycyclic aryl group. The aryl group as each of Rₐ and R_{b} may be independently selected from the group consisting of a phenyl group, a naphthyl group, an anthryl group (an univalent radical derived from anthracene), a chrysenyl group (an univalent radical derived from chrysene), a pyrenyl group (an univalent radical derived from pyrene), a phenanthryl group (an univalent radical derived from phenanthrene), a triphenylenyl group (an univalent radical derived from triphenylene), a fluorenyl group (an univalent radical derived from flourene), and a 9,9'-spirofluorenyl group (an univalent radical derived from 9,9'-spirofluorene).

According to an example embodiment of the present disclosure, the compound represented by the Chemical Formula 2 may include or be one selected from the group consisting of following compound GHH-1 to compound GHH-20. However, the specific example of the compound represented by the Chemical Formula 2 of the present disclosure is not limited thereto as long as it meets the above definition of the Chemical Formula 2:

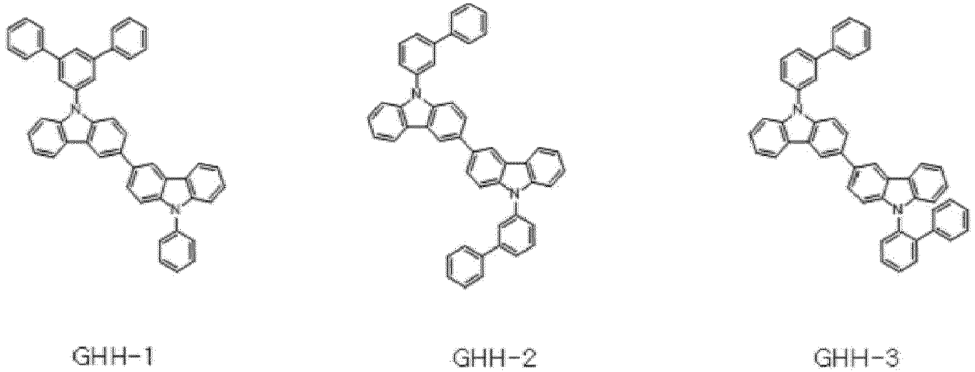

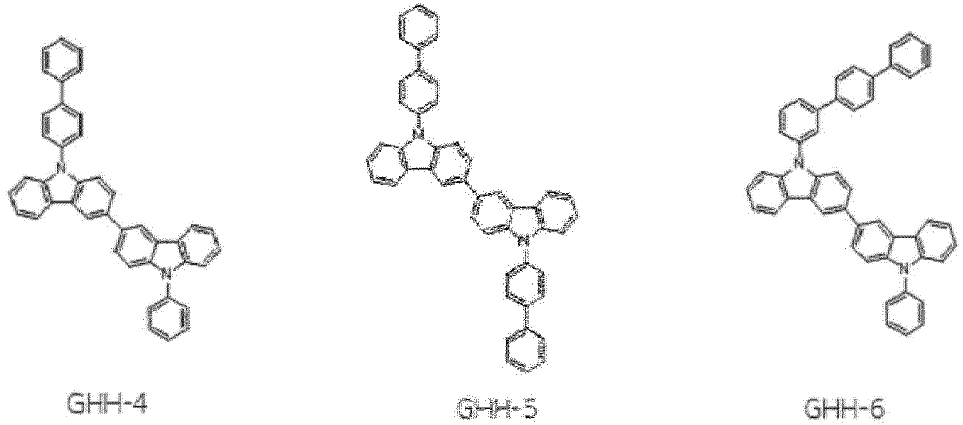

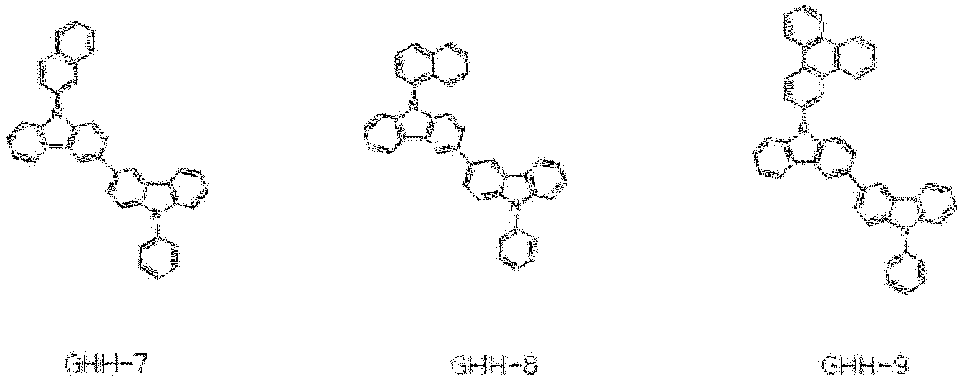

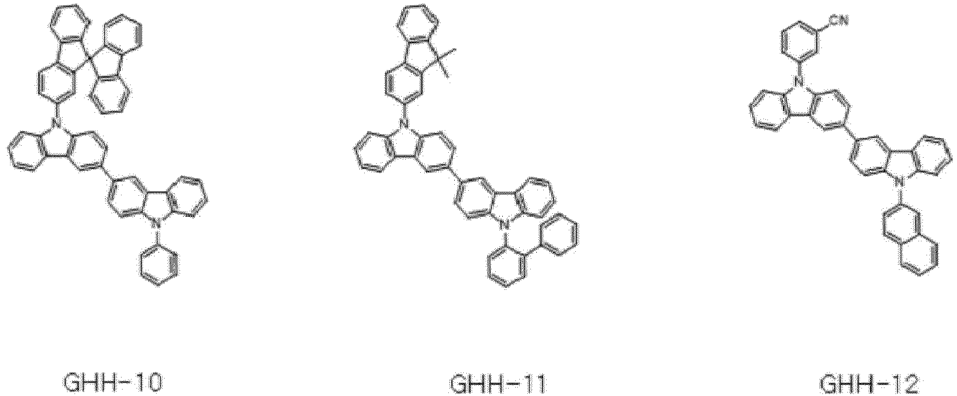

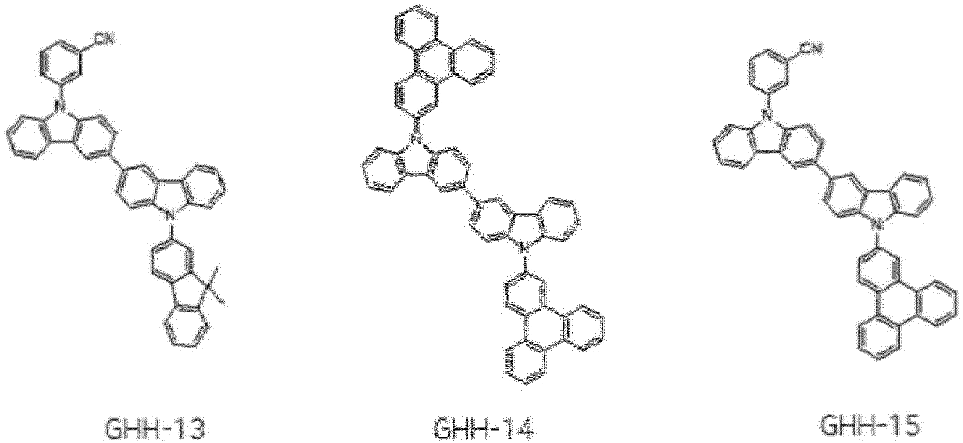

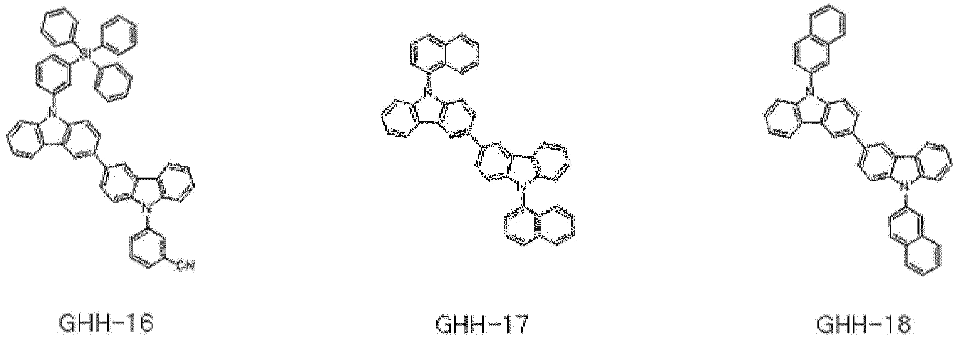

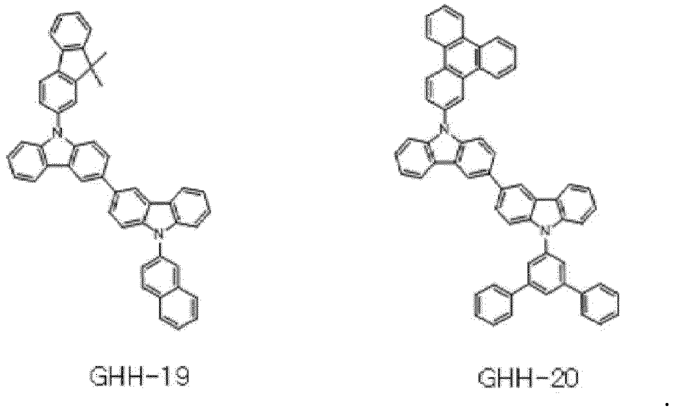

According to an example embodiment of the present disclosure, both X₄ and X₅ in the Chemical Formula 3 may be N.

According to an example embodiment of the present disclosure, L in the Chemical Formula 3 may be a single bond or a phenylene group. In some embodiments, L is a single bond.

According to an example embodiment of the present disclosure, each of R₉ to R₂₄ of the Chemical Formula 3 may independently represent one selected from the group consisting of hydrogen, deuterium, a C1 to C10 alkyl group, a C7 to C20 arylalkyl group, a C6 to C30 aryl group, and a C2 to C30 heteroaryl group.

According to an example embodiment of the present disclosure, each of R₉ to R₂₂ of Chemical Formula 3 may independently represent one selected from the group consisting of hydrogen, a C1 to C10 alkyl group and a C6 to C30 aryl group. In some embodiments, R₉ to R₂₂ may be hydrogen or a C1 to C5 alkyl group.

According to an example embodiment of the present disclosure, R₂₃ of the Chemical Formula 3 may independently represent one selected from the group consisting of hydrogen, deuterium, and a C1 to C10 alkyl group. In some embodiments, R₂₃ may be hydrogen or a C1 to C5 alkyl group.

According to an example embodiment of the present disclosure, R₂₄ of the Chemical Formula 3 may independently represent one selected from the group consisting of hydrogen, a C1 to C10 alkyl group, a C7 to C20 arylalkyl group, a C6 to C30 aryl group, and a C2 to C30 heteroaryl group. In some embodiments, R₂₄ of the Chemical Formula 3 may independently represent one selected from the group consisting of hydrogen, a C7 to C20 arylalkyl group, a C6 to C30 aryl group, and a C2 to C30 heteroaryl group.

According to an example embodiment of the present disclosure, the compound represented by the Chemical Formula 3 may include or be one selected from the group consisting of following compound GEH-1 to compound GEH-20. However, the specific example of the compound represented by the Chemical Formula 3 of the present disclosure is not limited thereto as long as it meets the above definition of the Chemical Formula 3:

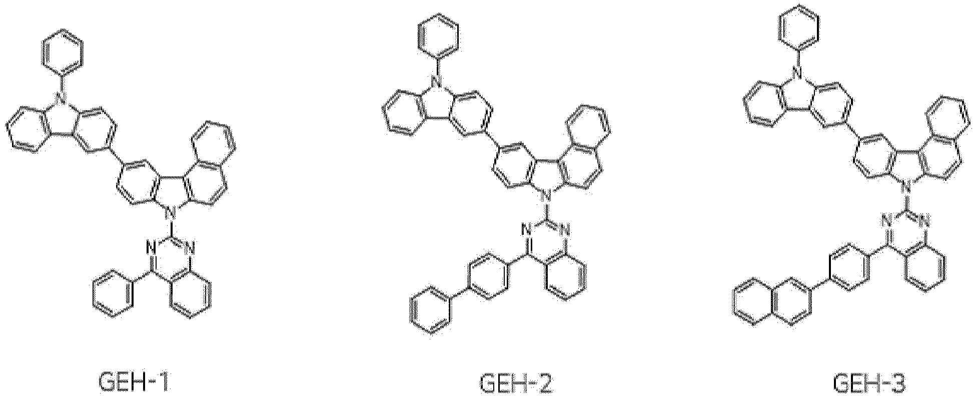

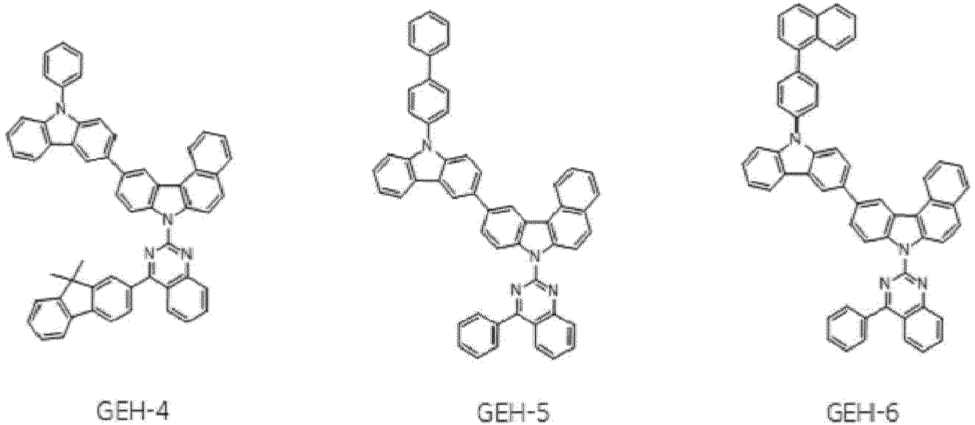

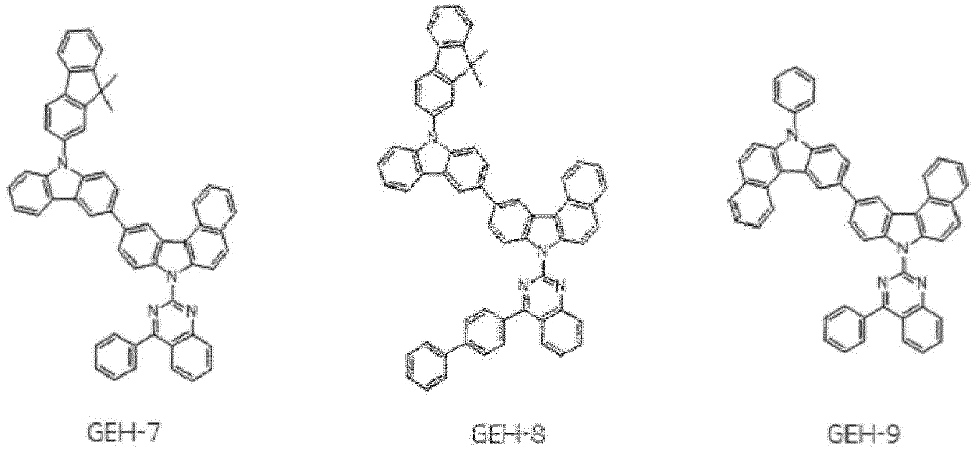

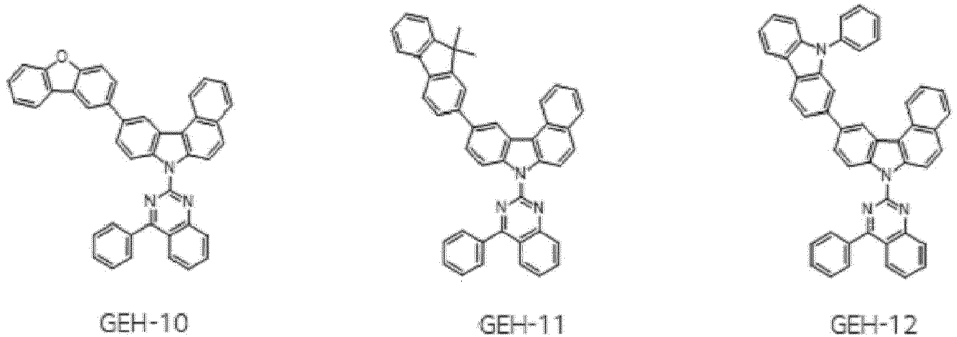

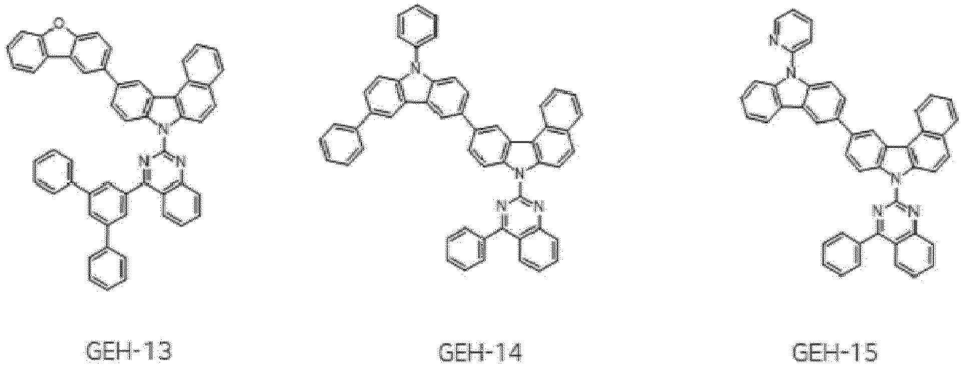

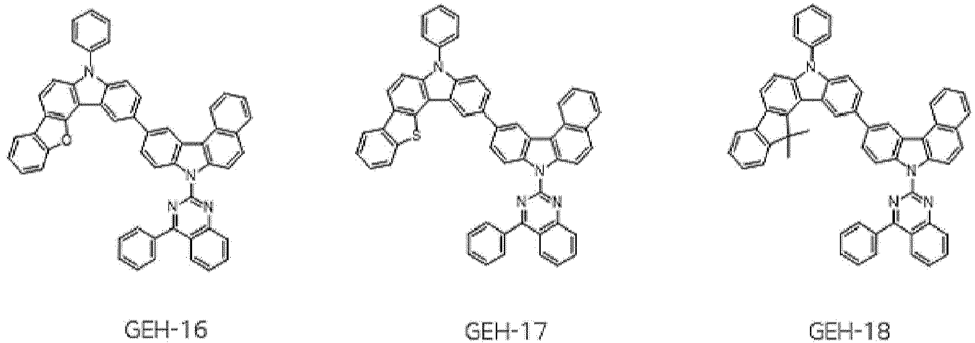

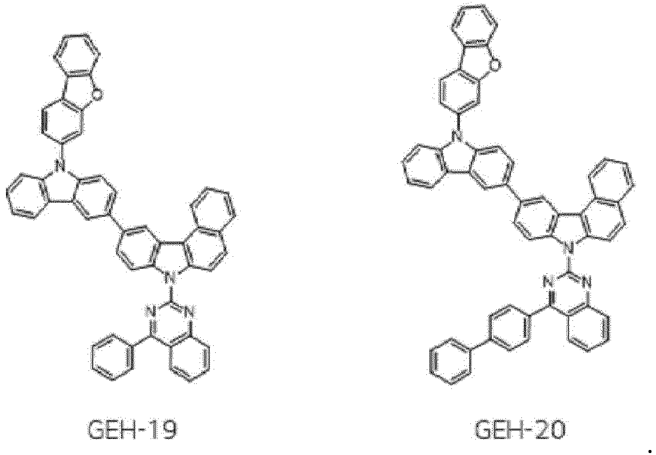

In addition, in the organic light-emitting diode 100, the organic layer 130 disposed between the first electrode 110 and the second electrode 120 may be formed by sequentially stacking a hole injection layer 140 (HIL), a hole transport layer 150 (HTL), a light emission layer 160 (EML), an electron transport layer 170 (ETL) and an electron injection layer 180 (EIL) on the first electrode 110. The second electrode 120 may be formed or disposed on the electron injection layer 180, and a protective layer (not shown) may be formed thereon.

Further, although not illustrated in FIG. 1, a hole transport auxiliary layer may be further added between the hole transport layer 150 and the light-emitting layer 160. The hole transport auxiliary layer may contain a compound having good hole transport properties, and may reduce a difference between HOMO energy levels of the hole transport layer 150 and the light-emitting layer 160 to adjust the hole injection properties. Thus, accumulation of holes at an interface between the hole transport auxiliary layer and the light-emitting layer 160 may be reduced, thereby reducing a quenching phenomenon in which excitons disappear at the interface due to polarons. Accordingly, deterioration of the element may be reduced, and the element may be stabilized, thereby improving efficiency and lifespan thereof.

The first electrode 110 may act as a positive electrode, and may be made of or include ITO, IZO, tin-oxide, or zinc-oxide as a conductive material having a relatively large work function value. However, the present disclosure is not limited thereto.

The second electrode 120 may act as a negative electrode, and may include Al, Mg, Ca, or Ag as a conductive material having a relatively small work function value, or an alloy or combination thereof. However, the present disclosure is not limited thereto.

The hole injection layer 140 may be positioned between the first electrode 110 and the hole transport layer 150. The hole injection layer 140 may have a function of improving interface characteristics between the first electrode 110 and the hole transport layer 150, and may be selected from a material having appropriate conductivity. The hole injection layer 140 may include a compound selected from the group consisting of MTDATA, CuPc, TCTA, HATCN, TDAPB, PEDOT/PSS, and N1,N1'-([1,1'-biphenyl]-4,4'-diyl)bis(N1,N4,N4)-triphenylbenzene-1,4-diamine). In some embodiments, the hole injection layer 140 may include N1,N1'-([1,1'-biphenyl]-4,4'-diyl)bis(N1,N4,N4-triphenylbenzene-1,4-diamine). However, the present disclosure is not limited thereto.

The hole transport layer 150 may be positioned adjacent to the light-emitting layer and between the first electrode 110 and the light-emitting layer 160. A material of the hole transport layer 150 may include a compound selected from the group consisting of TPD, NPB, CBP, N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl)-4-amine, etc. In some embodiments, the material of the hole transport layer 150 may include NPB. However, the present disclosure is not limited thereto.

According to an example embodiment of the present disclosure, the light-emitting layer 160 may be formed by doping the mixture of the host materials 160" and 160‴ with the organometallic compound represented by the Chemical Formula 1 as the dopant 160' to improve luminous efficiency of the diode 100. The dopant 160' may be used as a green or red light-emitting material. In some embodiments, the dopant 160' may be used as a green phosphorescent material.

According to an example embodiment of the present disclosure, a doping concentration of the dopant 160' may be adjusted to be within a range of 1 to 30% by weight based on a total weight of the mixture of the two host materials 160" and 160'". However, the disclosure is not limited thereto. For example, the doping concentration may be in a range of 2 to 20 wt%, for example, 3 to 15 wt%, for example, 5 to 10 wt%, for example, 3 to 8 wt%, for example, 2 to 7 wt%, for example, 5 to 7 wt%, or for example, 5 to 6 wt%.

According to an example embodiment of the present disclosure, the mixing ratio of the two types of hosts 160" and 160'" is not particularly limited. The host 160" which is the compound represented by the Chemical Formula 2 may have hole transport properties. The host 160" which is the compound represented by the Chemical Formula 3 may have electron transport characteristics. Thus, the mixture of the two kinds of hosts may achieve the advantage of increasing the lifespan characteristics of the element. The mixing ratio of the two types of hosts may be appropriately adjusted. Therefore, the mixing ratio of the two hosts, which are the compound represented by the Chemical Formula 2 and the compound represented by the Chemical Formula 3, is not particularly limited. The mixing ratio (based on a weight) of the compound represented by the Chemical Formula 2 and the compound represented by the Chemical Formula 3 may be, for example, in a range of 1:9 to 9: 1, for example, may be 2:8, for example, may be 3:7, for example, may be 4:6, for example, may be 5:5, for example, may be 6:4, for example, may be 7:3, for example, may be 8:2.

Further, the electron transport layer 170 and the electron injection layer 180 may be sequentially stacked between the light-emitting layer 160 and the second electrode 120. A material of the electron transport layer 170 may exhibit high electron mobility such that electrons may be stably supplied to the light-emitting layer under smooth electron transport.

For example, a material of the electron transport layer 170 may be known in the art and may include a compound selected from the group consisting of Alq3 (tris(8-hydroxyquinolino)aluminum), Liq (8-hydroxyquinolinolatolithium), PBD (2-(4-biphenylyl)-5-(4-tert-butylphenyl)-1,3,4oxadiazole), TAZ (3-(4-biphenyl)4-phenyl-5-tert-butylphenyl-1,2,4-triazole), spiro-PBD, BAlq (bis(2-methyl-8-quinolinolate)-4-(phenylphenolato)aluminium), Salq, TPBi (2,2',2-(1,3,5-benzinetriyl)-tris(1-phenyl-1-H-benzimidazole), oxadiazole, triazole, phenanthroline, benzoxazole, benzothiazole, and 2-(4-(9,10-di(naphthalen-2-yl)anthracen-2-yl)phenyl)-1-phenyl-1H-benzo[d]imidazole. In some embodiments, the material of the electron transport layer 170 may include 2-(4-(9,10-di(naphthalen-2-yl)anthracen-2-yl)phenyl)-1-phenyl-1H-benzo[d]imidazole. However, the present disclosure is not limited thereto.

The electron injection layer 180 may facilitate electron injection. A material of the electron injection layer may be known in the art and may include a compound selected from the group consisting of Alq3 (tris(8-hydroxyquinolino)aluminum), PBD, TAZ, spiro-PBD, Balq, Salq, etc. However, the present disclosure is not limited thereto. In some embodiments, the electron injection layer 180 may be made of or include a metal compound. The metal compound may include, for example, one or more selected from the group consisting of Liq, LiF, NaF, KF, RbF, CsF, FrF, BeF₂, MgF₂, CaF₂, SrF₂, BaF₂ and RaF₂. However, the present disclosure is not limited thereto.

The organic light-emitting diode according to the present disclosure may be embodied as a white light-emitting diode having a tandem structure. The tandem organic light-emitting diode according to an illustrative embodiment of the present disclosure may be formed in a structure in which adjacent stacks among two or more light-emitting stacks are connected to each other via a charge generation layer (CGL). The organic light-emitting diode may include at least two light-emitting stacks disposed on a substrate. Each of the at least two light-emitting stacks may include a light-emitting layer, and the light-emitting layer disposed between the first and second electrodes may emit light in a specific wavelength band. The first and the second electrodes may face each other. The plurality of light-emitting stacks may emit light of the same color or different colors. In addition, one or more light-emitting layers may be included in one light-emitting stack, and the plurality of light-emitting layers may emit light of the same color or different colors.

In an example embodiment, the light-emitting layer included in at least one of the plurality of light-emitting stacks may contain the organometallic compound represented by the Chemical Formula 1 according to the present disclosure as the dopant. Adjacent stacks among the plurality of light-emitting stacks in the tandem structure may be connected to each other via the charge generation layer CGL including an N-type charge generation layer and a P-type charge generation layer.

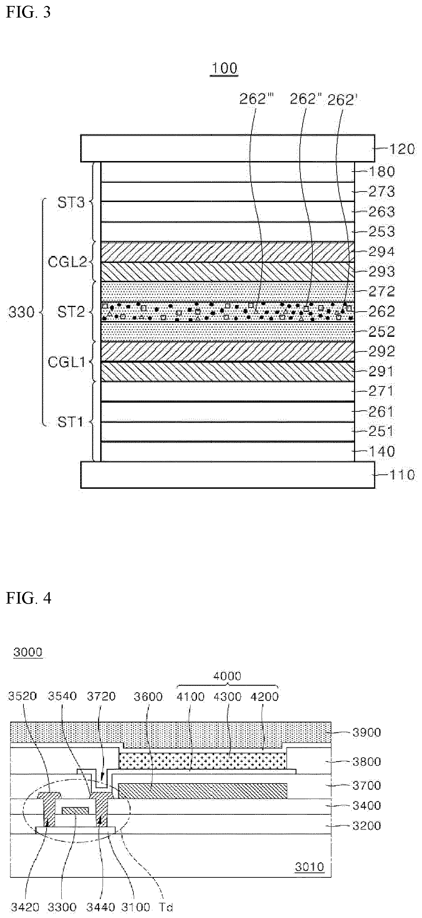

FIG. 2 and FIG. 3 are cross-sectional views schematically showing an organic light-emitting diode in a tandem structure having two light-emitting stacks and an organic light-emitting diode in a tandem structure having three light-emitting stacks, respectively, according to some example embodiments of the present disclosure.

As illustrated in FIG. 2, an organic light-emitting diode 100 according to the present disclosure may include a first electrode 110 and a second electrode 120 facing each other, and an organic layer 230 may be positioned between the first electrode 110 and the second electrode 120. The organic layer 230 may include a first light-emitting stack ST1 including a first light-emitting layer 261, a second light-emitting stack ST2 positioned between the first light-emitting stack ST1 and the second electrode 120 and including a second light-emitting layer 262, and the charge generation layer CGL positioned between the first and second light-emitting stacks ST1 and ST2. The charge generation layer CGL may include an N-type charge generation layer 291 and a P-type charge generation layer 292. At least one of the first light-emitting layer 261 and the second light-emitting layer 262 may contain the organometallic compound represented by the Chemical Formula 1 according to the present disclosure as the dopant 262'. For example, as illustrated in FIG. 2, the second light-emitting layer 262 of the second light-emitting stack ST2 may include a compound 262' represented by the Chemical Formula 1 as a dopant, a compound 262" represented by the Chemical Formula 2 as a hole transporting host, and a compound 262‴ represented by the Chemical Formula 3 as an electron transporting host. Although not illustrated in FIG. 2, each of the first and second light-emitting stacks ST1 and ST2 may further include an additional light-emitting layer in addition to each of the first light-emitting layer 261 and the second light-emitting layer 262. The description as set forth above with respect to the hole transport layer 150 of FIG. 1 may be applied in the same or similar manner to each of the first hole transport layer 251 and the second hole transport layer 252 of FIG. 2. Moreover, the description as set forth above with respect to the electron transport layer 170 of FIG. 1 may be applied in the same or similar manner to each of the first electron transport layer 271 and the second electron transport layer 272 of FIG. 2.

As illustrated in FIG. 3, the organic light-emitting diode 100 according to the present disclosure may include the first electrode 110 and the second electrode 120 facing each other, and an organic layer 330 positioned between the first electrode 110 and the second electrode 120. The organic layer 330 may be positioned between the first electrode 110 and the second electrode 120 and may include the first light-emitting stack ST1 including the first light-emitting layer 261, the second light-emitting stack ST2 including the second light-emitting layer 262, a third light-emitting stack ST3 including a third light-emitting layer 263, a first charge generation layer CGL1 positioned between the first and second light-emitting stacks ST1 and ST2, and a second charge generation layer CGL2 positioned between the second and third light-emitting stacks ST2 and ST3. The first charge generation layer CGL1 may include a N-type charge generation layer 291 and a P-type charge generation layer 292. The second charge generation layer CGL2 may include a N-type charge generation layer 293 and a P-type charge generation layer 294. At least one of the first light-emitting layer 261, the second light-emitting layer 262, and the third light-emitting layer 263 may contain the organometallic compound represented by the Chemical Formula 1 according to the present disclosure as the dopant. For example, as illustrated in FIG. 3, the second light-emitting layer 262 of the second light-emitting stack ST2 may include the compound 262' represented by the Chemical Formula 1 as a dopant, the compound 262" represented by the Chemical Formula 2 as a hole transporting host, and the compound 262'" represented by the Chemical Formula 3 as an electron transporting host. Although not illustrated in FIG. 3, each of the first, second and third light-emitting stacks ST1, ST2 and ST3 may further include an additional light-emitting layer, in addition to each of the first light-emitting layer 261, the second light-emitting layer 262 and the third light-emitting layer 263. The description as set forth above with respect to the hole transport layer 150 of FIG. 1 may be applied in the same or similar manner to each of the first hole transport layer 251, the second hole transport layer 252, and the third hole transport layer 253 of FIG. 3. Moreover, the description as set forth above with respect to the electron transport layer 170 of FIG. 1 may be applied in the same or similar manner to each of the first electron transport layer 271, the second electron transport layer 272, and the third electron transport layer 273 of FIG. 3.

Furthermore, an organic light-emitting diode according to an embodiment of the present disclosure may include a tandem structure including four or more light-emitting stacks and three or more charge generating layers disposed between the first electrode and the second electrode.

The organic light-emitting diode according to the present disclosure may be used as a light-emitting element of each of an organic light-emitting display device and a lighting device. In an example embodiment, FIG. 4 is a cross-sectional view schematically illustrating an organic light-emitting display device including the organic light-emitting diode according to some embodiments of the present disclosure as a light-emitting element thereof.

As illustrated in FIG. 4, an organic light-emitting display device 3000 includes a substrate 3010, an organic light-emitting diode 4000, and an encapsulation film 3900 covering the organic light-emitting diode 4000. A driving thin-film transistor Td as a driving element, and the organic light-emitting diode 4000 connected to the driving thin-film transistor Td are positioned on the substrate 3010.

Although not illustrated explicitly in FIG. 4, a gate line and a data line that intersect each other to define a pixel area, a power line extending parallel to and spaced from one of the gate line and the data line, a switching thin film transistor connected to the gate line and the data line, and a storage capacitor connected to one electrode of the thin film transistor and the power line are further formed or disposed on the substrate 3010.

The driving thin-film transistor Td is connected to the switching thin film transistor, and includes a semiconductor layer 3100, a gate electrode 3300, a source electrode 3520, and a drain electrode 3540.

The semiconductor layer 3100 may be formed or disposed on the substrate 3010 and may be made of or include an oxide semiconductor material or polycrystalline silicon. When the semiconductor layer 3100 is made of or include an oxide semiconductor material, a light-shielding pattern (not illustrated) may be formed under the semiconductor layer 3100. The light-shielding pattern may prevent or reduce the chances of light from being incident into the semiconductor layer 3100 to prevent or reduce the chances of the semiconductor layer 3100 from being deteriorated due to the light. In some embodiments, the semiconductor layer 3100 may be made of or include polycrystalline silicon. In an example embodiment, both edges of the semiconductor layer 3100 may be doped with impurities.

The gate insulating layer 3200 made of or include an insulating material is formed over an entirety of a surface of the substrate 3010 and on the semiconductor layer 3100. The gate insulating layer 3200 may be made of or include an inorganic insulating material such as silicon oxide or silicon nitride.

The gate electrode 3300 made of or include a conductive material such as a metal is formed or disposed on the gate insulating layer 3200 and corresponds to a center of the semiconductor layer 3100. The gate electrode 3300 is connected to the switching thin film transistor.

The interlayer insulating layer 3400 made of or include an insulating material is formed over the entirety of the surface of the substrate 3010 and on the gate electrode 3300. The interlayer insulating layer 3400 may be made of or include an inorganic insulating material such as silicon oxide or silicon nitride, or an organic insulating material such as benzocyclobutene or photo-acryl.

The interlayer insulating layer 3400 has first and second semiconductor layer contact holes 3420 and 3440 defined therein respectively exposing both opposing sides of the semiconductor layer 3100. The first and second semiconductor layer contact holes 3420 and 3440 are respectively positioned on both opposing sides of the gate electrode 3300 and are spaced apart from the gate electrode 3300.

The source electrode 3520 and the drain electrode 3540 made of or include a conductive material such as metal are formed or disposed on the interlayer insulating layer 3400. The source electrode 3520 and the drain electrode 3540 are positioned around the gate electrode 3300, and are spaced apart from each other, and respectively contact both opposing sides of the semiconductor layer 3100 via the first and second semiconductor layer contact holes 3420 and 3440, respectively. The source electrode 3520 is connected to a power line (not illustrated).

The semiconductor layer 3100, the gate electrode 3300, the source electrode 3520, and the drain electrode 3540 constitute the driving thin-film transistor Td. The driving thin-film transistor Td has a coplanar structure in which the gate electrode 3300, the source electrode 3520, and the drain electrode 3540 are positioned on top of the semiconductor layer 3100.

In some embodiments, the driving thin-film transistor Td may have an inverted staggered structure in which the gate electrode is disposed under the semiconductor layer while the source electrode and the drain electrode are disposed above the semiconductor layer. In an example embodiment, the semiconductor layer may be made of or include amorphous silicon. In an example, the switching thin-film transistor (not illustrated) may have substantially the same structure as that of the driving thin-film transistor (Td).

In an example, the organic light-emitting display device 3000 may include a color filter 3600 absorbing the light generated from the electroluminescent element (light-emitting diode) 4000. For example, the color filter 3600 may absorb red (R), green (G), blue (B), and white (W) light. In an example embodiment, red, green, and blue color filter patterns that absorb light may be formed separately in different pixel areas. Each of these color filter patterns may be disposed to overlap each organic layer 4300 of the organic light-emitting diode 4000 to emit light of a wavelength band corresponding to each color filter. Adopting the color filter 3600 may allow the organic light-emitting display device 3000 to realize full-color.

For example, when the organic light-emitting display device 3000 is of a bottom emission type, the color filter 3600 absorbing light may be positioned on a portion of the interlayer insulating layer 3400 corresponding to the organic light-emitting diode 4000. In some embodiments, when the organic light-emitting display device 3000 is of a top emission type, the color filter may be positioned on top of the organic light-emitting diode 4000, that is, on top of a second electrode 4200. For example, the color filter 3600 may be formed to have a thickness of 2 to 5 µm.

In an example, a planarization layer 3700 having a drain contact hole 3720 defined therein exposing the drain electrode 3540 of the driving thin-film transistor Td is formed to cover the driving thin-film transistor Td.

On the planarization layer 3700, each first electrode 4100 connected to the drain electrode 3540 of the driving thin-film transistor Td via the drain contact hole 3720 is formed individually in each pixel area.

The first electrode 4100 may act as a positive electrode (anode), and may be made of or include a conductive material having a relatively large work function value. For example, the first electrode 4100 may be made of or include a transparent conductive material such as ITO, IZO or ZnO.

In an example, when the organic light-emitting display device 3000 is of a top-emission type, a reflective electrode or a reflective layer may be further formed under the first electrode 4100. For example, the reflective electrode or the reflective layer may be made of or include one of aluminum (Al), silver (Ag), nickel (Ni), and an aluminum-palladium-copper (APC) alloy.

A bank layer 3800 covering an edge of the first electrode 4100 is formed or disposed on the planarization layer 3700. The bank layer 3800 exposes a center of the first electrode 4100 corresponding to the pixel area.

An organic layer 4300 is formed or disposed on the first electrode 4100. In some embodiments, the organic light-emitting diode 4000 may have a tandem structure, as illustrated in the example embodiments of FIG. 2 to FIG. 4.

The second electrode 4200 is formed or disposed on the substrate 3010 on which the organic layer 4300 has been formed. The second electrode 4200 is disposed over the entirety of the surface of the display area and is made of or include a conductive material having a relatively small work function value and may be used as a negative electrode (a cathode). For example, the second electrode 4200 may be made of or include one of aluminum (Al), magnesium (Mg), and an aluminum-magnesium alloy (Al-Mg).

The first electrode 4100, the organic layer 4300, and the second electrode 4200 constitute the organic light-emitting diode 4000.

An encapsulation film 3900 is formed or disposed on the second electrode 4200 to prevent or reduce external moisture from penetrating into the organic light-emitting diode 4000. Although not illustrated explicitly in FIG. 4, the encapsulation film 3900 may have a triple-layer structure in which a first inorganic layer, an organic layer, and an inorganic layer are sequentially stacked. However, the present disclosure is not limited thereto.

Hereinafter, Present Examples of the present disclosure will be described. However, following Present Examples are only examples of the present disclosure. The present disclosure is not limited thereto.

### Examples

### Present Example 1

A glass substrate having a thin film of ITO (indium tin oxide) having a thickness of 1,000 Å coated thereon was washed, followed by ultrasonic cleaning with a solvent such as isopropyl alcohol, acetone, or methanol. Then, the glass substrate was dried. Thus, an ITO transparent electrode was formed.

HI-1 as a hole injection material was deposited on the ITO transparent electrode in a thermal vacuum deposition manner. Thus, a hole injection layer having a thickness of 100 nm was formed. Then, HT-1 as a hole transport material was deposited on the hole injection layer in a thermal vacuum deposition manner. Thus, a hole transport layer having a thickness of 350 nm was formed. Then, GD-1 was used as a dopant in a light-emitting layer and a mixture of GHH-1 and GEH-1 (GHH-1: GEH-1 = 7: 3 based on a weight) was used as a host. The host material mixture was deposited on the hole transport layer via a thermal vacuum deposition. The dopant was doped into the host material mixture at a doping concentration of 10%. Thus, the light-emitting layer of a thickness of 400 nm was formed. Each of ET-1 and Liq (1:1) as a material of each of an electron transport layer and an electron injection layer was deposited on the light-emitting layer. Then, 100 nm thick aluminum was deposited thereon to form a negative electrode. In this way, an organic light-emitting diode was manufactured.

The materials used in Present Example 1 are as follows. 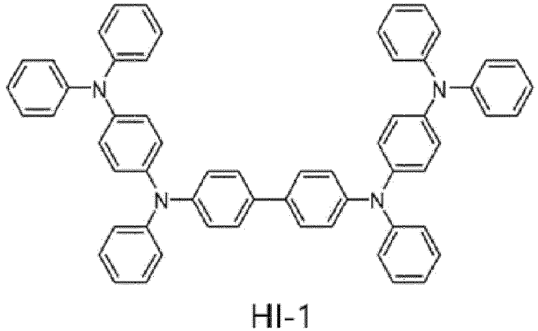 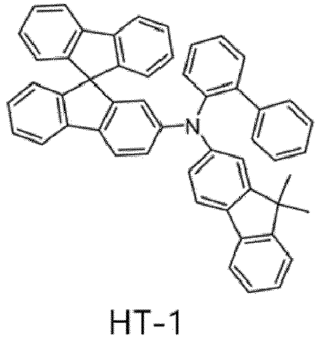 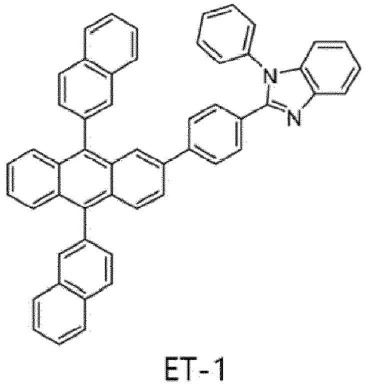 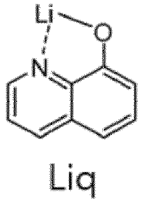 HI-1 is NPNPB, and ET- 1 is ZADN.

Comparative Examples 1 to 5, and Present Examples 2 to 200

An organic light-emitting diode each of Comparative Examples 1 to 5, and Present Examples 2 to 200 was manufactured in the same manner as in Present Example 1, except that the dopant materials and the host materials as described in following Tables 1 to 15 were used instead of the dopant material and the host materials in Present Example 1. In each of Comparative Examples 1 to 5, CBP having the following structure was used as a host.

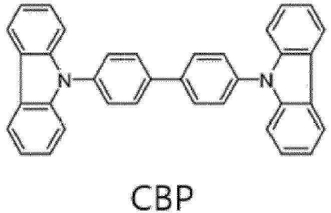

### Experimental example

The organic light-emitting diode as manufactured in each of Present Examples 1 to 200 and Comparative Examples 1 to 5 was connected to an external power source, and characteristics of the organic light-emitting diode were evaluated at room temperature using a current source and a photometer.

Specifically, operation voltage (V), external quantum efficiency (EQE; %), and lifetime characteristics (LT95; %) were measured at a current of 10 mA/cm², and were calculated as relative values to those of one of Comparative Examples 1 to 5, and the results are illustrated in the following Tables 1 to 15.

LT95 lifetime refers to a time it takes for the display element to lose 5% of its initial brightness. LT95 is the customer specification that may be the most difficult to meet. Whether or not image burn-in occurs on the display may be determined based on the LT95.

**[Table 1]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 1 | GD-1 | GHH-1 | GEH-1 | 4.22 | 123 | 118 |
| Present Example 2 | GD-1 | GHH-1 | GEH-2 | 4.21 | 122 | 118 |
| Present Example 3 | GD-1 | GHH-1 | GEH-3 | 4.23 | 126 | 118 |
| Present Example 4 | GD-1 | GHH-1 | GEH-4 | 4.11 | 125 | 119 |
| Present Example 5 | GD-1 | GHH-1 | GEH-5 | 4.11 | 125 | 114 |
| Present Example 6 | GD-1 | GHH-1 | GEH-6 | 4.24 | 124 | 115 |
| Present Example 7 | GD-1 | GHH-1 | GEH-7 | 4.16 | 122 | 114 |
| Present Example 8 | GD-1 | GHH-1 | GEH-8 | 4.16 | 125 | 116 |
| Present Example 9 | GD-1 | GHH-1 | GEH-9 | 4.14 | 116 | 110 |
| Present Example 10 | GD-1 | GHH-1 | GEH-10 | 4.29 | 122 | 113 |
| Present Example 11 | GD-1 | GHH-2 | GEH-1 | 4.17 | 132 | 123 |
| Present Example 12 | GD-1 | GHH-2 | GEH-2 | 4.19 | 128 | 126 |
| Present Example 13 | GD-1 | GHH-2 | GEH-3 | 4.08 | 131 | 123 |
| Present Example 14 | GD-1 | GHH-2 | GEH-4 | 4.14 | 131 | 122 |
| Present Example 15 | GD-1 | GHH-2 | GEH-5 | 4.18 | 132 | 120 |

**[Table 2]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 16 | GD-1 | GHH-2 | GEH-6 | 4.07 | 130 | 122 |
| Present Example 17 | GD-1 | GHH-2 | GEH-7 | 4.08 | 129 | 118 |
| Present Example 18 | GD-1 | GHH-2 | GEH-8 | 4.20 | 133 | 126 |
| Present Example 19 | GD-1 | GHH-2 | GEH-9 | 4.19 | 126 | 120 |
| Present Example 20 | GD-1 | GHH-2 | GEH-10 | 4.14 | 128 | 123 |
| Present Example 21 | GD-1 | GHH-3 | GEH-1 | 4.15 | 123 | 115 |
| Present Example 22 | GD-1 | GHH-3 | GEH-2 | 4.09 | 122 | 119 |
| Present Example 23 | GD-1 | GHH-3 | GEH-3 | 4.11 | 119 | 114 |
| Present Example 24 | GD-1 | GHH-3 | GEH-4 | 4.25 | 123 | 118 |
| Present Example 25 | GD-1 | GHH-3 | GEH-5 | 4.20 | 118 | 116 |
| Present Example 26 | GD-1 | GHH-3 | GEH-6 | 4.23 | 120 | 110 |
| Present Example 27 | GD-1 | GHH-3 | GEH-7 | 4.21 | 118 | 114 |
| Present Example 28 | GD-1 | GHH-3 | GEH-8 | 4.21 | 121 | 115 |
| Present Example 29 | GD-1 | GHH-3 | GEH-9 | 4.17 | 116 | 111 |
| Present Example 30 | GD-1 | GHH-3 | GEH-10 | 4.22 | 120 | 113 |

**[Table 3]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 31 | GD-1 | GHH-4 | GEH-1 | 4.26 | 132 | 130 |
| Present Example 32 | GD-1 | GHH-4 | GEH-2 | 4.01 | 132 | 128 |
| Present Example 33 | GD-1 | GHH-4 | GEH-3 | 4.17 | 136 | 125 |
| Present Example 34 | GD-1 | GHH-4 | GEH-4 | 4.18 | 134 | 124 |
| Present Example 35 | GD-1 | GHH-4 | GEH-5 | 4.21 | 134 | 124 |
| Present Example 36 | GD-1 | GHH-4 | GEH-6 | 4.21 | 132 | 124 |
| Present Example 37 | GD-1 | GHH-4 | GEH-7 | 4.18 | 133 | 121 |
| Present Example 38 | GD-1 | GHH-4 | GEH-8 | 4.11 | 132 | 123 |
| Present Example 39 | GD-1 | GHH-4 | GEH-9 | 4.15 | 128 | 119 |
| Present Example 40 | GD-1 | GHH-4 | GEH-10 | 4.21 | 129 | 122 |
| Present Example 41 | GD-1 | GHH-5 | GEH-1 | 4.17 | 138 | 130 |
| Present Example 42 | GD-1 | GHH-5 | GEH-2 | 4.11 | 136 | 129 |
| Present Example 43 | GD-1 | GHH-5 | GEH-3 | 4.19 | 136 | 124 |
| Present Example 44 | GD-1 | GHH-5 | GEH-4 | 4.04 | 137 | 128 |
| Present Example 45 | GD-1 | GHH-5 | GEH-5 | 4.16 | 135 | 125 |

**[Table 4]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 46 | GD-1 | GHH-5 | GEH-6 | 4.25 | 136 | 124 |
| Present Example 47 | GD-1 | GHH-5 | GEH-7 | 4.18 | 131 | 127 |
| Present Example 48 | GD-1 | GHH-5 | GEH-8 | 4.28 | 142 | 125 |
| Present Example 49 | GD-1 | GHH-5 | GEH-9 | 4.32 | 129 | 119 |
| Present Example 50 | GD-1 | GHH-5 | GEH-10 | 4.11 | 131 | 126 |
| Present Example 51 | GD-1 | GHH-6 | GEH-1 | 4.32 | 125 | 129 |
| Present Example 52 | GD-1 | GHH-6 | GEH-2 | 4.18 | 124 | 132 |
| Present Example 53 | GD-1 | GHH-6 | GEH-3 | 4.19 | 127 | 122 |
| Present Example 54 | GD-1 | GHH-6 | GEH-4 | 4.13 | 128 | 125 |
| Present Example 55 | GD-1 | GHH-6 | GEH-5 | 4.23 | 127 | 125 |
| Present Example 56 | GD-1 | GHH-6 | GEH-6 | 4.26 | 127 | 121 |
| Present Example 57 | GD-1 | GHH-6 | GEH-7 | 4.16 | 122 | 124 |
| Present Example 58 | GD-1 | GHH-6 | GEH-8 | 4.22 | 125 | 123 |
| Present Example 59 | GD-1 | GHH-6 | GEH-9 | 4.33 | 125 | 123 |
| Present Example 60 | GD-1 | GHH-6 | GEH-10 | 4.10 | 125 | 127 |

**[Table 5]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 61 | GD-1 | GHH-7 | GEH-1 | 4.28 | 123 | 118 |
| Present Example 62 | GD-1 | GHH-7 | GEH-2 | 4.22 | 124 | 121 |
| Present Example 63 | GD-1 | GHH-7 | GEH-3 | 4.17 | 120 | 118 |
| Present Example 64 | GD-1 | GHH-7 | GEH-4 | 4.10 | 123 | 118 |
| Present Example 65 | GD-1 | GHH-7 | GEH-5 | 4.10 | 122 | 116 |
| Present Example 66 | GD-1 | GHH-7 | GEH-6 | 4.19 | 117 | 115 |
| Present Example 67 | GD-1 | GHH-7 | GEH-7 | 4.27 | 120 | 114 |
| Present Example 68 | GD-1 | GHH-7 | GEH-8 | 4.20 | 119 | 115 |
| Present Example 69 | GD-1 | GHH-7 | GEH-9 | 4.12 | 117 | 113 |
| Present Example 70 | GD-1 | GHH-7 | GEH-10 | 4.30 | 120 | 113 |
| Present Example 71 | GD-1 | GHH-8 | GEH-1 | 4.20 | 122 | 126 |
| Present Example 72 | GD-1 | GHH-8 | GEH-2 | 4.22 | 119 | 130 |
| Present Example 73 | GD-1 | GHH-8 | GEH-3 | 4.18 | 122 | 124 |
| Present Example 74 | GD-1 | GHH-8 | GEH-4 | 4.14 | 121 | 126 |
| Present Example 75 | GD-1 | GHH-8 | GEH-5 | 4.23 | 121 | 123 |

**[Table 6]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 76 | GD-1 | GHH-8 | GEH-6 | 4.16 | 118 | 123 |
| Present Example 77 | GD-1 | GHH-8 | GEH-7 | 4.22 | 119 | 117 |
| Present Example 78 | GD-1 | GHH-8 | GEH-8 | 4.13 | 121 | 122 |
| Present Example 79 | GD-1 | GHH-8 | GEH-9 | 4.24 | 117 | 118 |
| Present Example 80 | GD-1 | GHH-8 | GEH-10 | 4.33 | 117 | 123 |
| Present Example 81 | GD-1 | GHH-9 | GEH-1 | 4.30 | 120 | 124 |
| Present Example 82 | GD-1 | GHH-9 | GEH-2 | 4.06 | 116 | 125 |
| Present Example 83 | GD-1 | GHH-9 | GEH-3 | 4.23 | 118 | 117 |
| Present Example 84 | GD-1 | GHH-9 | GEH-4 | 4.23 | 122 | 120 |
| Present Example 85 | GD-1 | GHH-9 | GEH-5 | 4.29 | 119 | 119 |
| Present Example 86 | GD-1 | GHH-9 | GEH-6 | 4.23 | 118 | 121 |
| Present Example 87 | GD-1 | GHH-9 | GEH-7 | 4.14 | 119 | 120 |
| Present Example 88 | GD-1 | GHH-9 | GEH-8 | 4.21 | 118 | 121 |
| Present Example 89 | GD-1 | GHH-9 | GEH-9 | 4.24 | 112 | 116 |
| Present Example 90 | GD-1 | GHH-9 | GEH-10 | 4.26 | 117 | 119 |

**[Table 7]**

| | Light-emitting layer | | | Operation voltage (V) | EQE (%, relative value) | LT95 (%, relative value) |
|---|---|---|---|---|---|---|
| | Dopant | Host | | | | |
| Comparative Example 1 | GD-1 | CBP | | 4.30 | 100 | 100 |
| Present Example 91 | GD-1 | GHH-10 | GEH-1 | 4.07 | 125 | 120 |
| Present Example 92 | GD-1 | GHH-10 | GEH-2 | 4.10 | 125 | 120 |
| Present Example 93 | GD-1 | GHH-10 | GEH-3 | 4.22 | 123 | 118 |
| Present Example 94 | GD-1 | GHH-10 | GEH-4 | 4.11 | 127 | 121 |
| Present Example 95 | GD-1 | GHH-10 | GEH-5 | 4.15 | 122 | 118 |
| Present Example 96 | GD-1 | GHH-10 | GEH-6 | 4.12 | 126 | 119 |
| Present Example 97 | GD-1 | GHH-10 | GEH-7 | 4.00 | 118 | 114 |
| Present Example 98 | GD-1 | GHH-10 | GEH-8 | 4.22 | 121 | 118 |
| Present Example 99 | GD-1 | GHH-10 | GEH-9 | 4.13 | 120 | 115 |
| Present Example 100 | GD-1 | GHH-10 | GEH-10 | 4.21 | 123 | 118 |

**[Table 8]**

| | Light-emitting layer | | | Operation voltage (V) | EQE (%, relative value) | LT95 (%, relative value) |
|---|---|---|---|---|---|---|
| | Dopant | Host | | | | |
| Comparative Example 2 | GD-2 | CBP | | 4.31 | 100 | 100 |
| Present Example 101 | GD-2 | GHH-1 | GEH-1 | 4.18 | 128 | 117 |
| Present Example 102 | GD-2 | GHH-1 | GEH-2 | 4.14 | 121 | 116 |
| Present Example 103 | GD-2 | GHH-1 | GEH-3 | 4.05 | 124 | 117 |
| Present Example 104 | GD-2 | GHH-1 | GEH-4 | 4.11 | 125 | 114 |
| Present Example 105 | GD-2 | GHH-1 | GEH-5 | 4.19 | 120 | 115 |
| Present Example 106 | GD-2 | GHH-2 | GEH-1 | 4.11 | 132 | 124 |
| Present Example 107 | GD-2 | GHH-2 | GEH-2 | 4.06 | 131 | 126 |
| Present Example 108 | GD-2 | GHH-2 | GEH-3 | 4.17 | 129 | 125 |
| Present Example 109 | GD-2 | GHH-2 | GEH-4 | 4.11 | 134 | 125 |
| Present Example 110 | GD-2 | GHH-2 | GEH-5 | 4.09 | 133 | 126 |
| Present Example 111 | GD-2 | GHH-3 | GEH-1 | 4.12 | 126 | 119 |
| Present Example 112 | GD-2 | GHH-3 | GEH-2 | 4.16 | 121 | 119 |
| Present Example 113 | GD-2 | GHH-3 | GEH-3 | 4.15 | 123 | 114 |
| Present Example 114 | GD-2 | GHH-3 | GEH-4 | 4.03 | 124 | 113 |
| Present Example 115 | GD-2 | GHH-3 | GEH-5 | 4.16 | 120 | 113 |

**[Table 9]**

| | Light-emitting layer | | | Operation voltage (V) | EQE (%, relative value) | LT95 (%, relative value) |
|---|---|---|---|---|---|---|
| | Dopant | Host | | | | |
| Comparative Example 2 | GD-2 | CBP | | 4.31 | 100 | 100 |
| Present Example 116 | GD-2 | GHH-4 | GEH-1 | 4.09 | 136 | 127 |
| Present Example 117 | GD-2 | GHH-4 | GEH-2 | 4.03 | 133 | 127 |
| Present Example 118 | GD-2 | GHH-4 | GEH-3 | 4.13 | 136 | 124 |
| Present Example 119 | GD-2 | GHH-4 | GEH-4 | 4.22 | 133 | 121 |
| Present Example 120 | GD-2 | GHH-4 | GEH-5 | 4.05 | 132 | 124 |
| Present Example 121 | GD-2 | GHH-5 | GEH-1 | 4.17 | 138 | 132 |
| Present Example 122 | GD-2 | GHH-5 | GEH-2 | 4.21 | 134 | 131 |
| Present Example 123 | GD-2 | GHH-5 | GEH-3 | 4.23 | 130 | 127 |
| Present Example 124 | GD-2 | GHH-5 | GEH-4 | 4.12 | 134 | 130 |
| Present Example 125 | GD-2 | GHH-5 | GEH-5 | 4.07 | 138 | 124 |

**[Table 10]**

| | Light-emitting layer | | | Operation voltage (V) | EQE (%, relative value) | LT95 (%, relative value) |
|---|---|---|---|---|---|---|
| | Dopant | Host | | | | |
| Comparative Example 3 | GD-3 | CBP | | 4.32 | 100 | 100 |
| Present Example 126 | GD-3 | GHH-1 | GEH-1 | 4.07 | 125 | 120 |
| Present Example 127 | GD-3 | GHH-1 | GEH-2 | 4.18 | 121 | 119 |
| Present Example 128 | GD-3 | GHH-1 | GEH-3 | 4.04 | 121 | 117 |
| Present Example 129 | GD-3 | GHH-1 | GEH-4 | 4.08 | 123 | 119 |
| Present Example 130 | GD-3 | GHH-1 | GEH-5 | 4.09 | 125 | 114 |
| Present Example 131 | GD-3 | GHH-2 | GEH-1 | 4.27 | 131 | 124 |
| Present Example 132 | GD-3 | GHH-2 | GEH-2 | 4.06 | 131 | 127 |
| Present Example 133 | GD-3 | GHH-2 | GEH-3 | 4.30 | 132 | 125 |
| Present Example 134 | GD-3 | GHH-2 | GEH-4 | 4.08 | 133 | 124 |
| Present Example 135 | GD-3 | GHH-2 | GEH-5 | 4.20 | 130 | 122 |
| Present Example 136 | GD-3 | GHH-3 | GEH-1 | 4.23 | 121 | 113 |
| Present Example 137 | GD-3 | GHH-3 | GEH-2 | 4.10 | 118 | 116 |
| Present Example 138 | GD-3 | GHH-3 | GEH-3 | 4.09 | 125 | 117 |
| Present Example 139 | GD-3 | GHH-3 | GEH-4 | 4.16 | 124 | 113 |
| Present Example 140 | GD-3 | GHH-3 | GEH-5 | 4.12 | 119 | 115 |

**[Table 11]**

| | Light-emitting layer | | | Operation voltage (V) | EQE (%, relative value) | LT95 (%, relative value) |
|---|---|---|---|---|---|---|
| | Dopant | Host | | | | |
| Comparative Example 3 | GD-3 | CBP | | 4.32 | 100 | 100 |
| Present Example 141 | GD-3 | GHH-4 | GEH-1 | 4.16 | 135 | 123 |
| Present Example 142 | GD-3 | GHH-4 | GEH-2 | 4.07 | 135 | 126 |
| Present Example 143 | GD-3 | GHH-4 | GEH-3 | 4.04 | 133 | 121 |
| Present Example 144 | GD-3 | GHH-4 | GEH-4 | 4.21 | 137 | 123 |
| Present Example 145 | GD-3 | GHH-4 | GEH-5 | 4.12 | 132 | 124 |
| Present Example 146 | GD-3 | GHH-5 | GEH-1 | 4.14 | 138 | 128 |
| Present Example 147 | GD-3 | GHH-5 | GEH-2 | 4.05 | 134 | 127 |
| Present Example 148 | GD-3 | GHH-5 | GEH-3 | 4.22 | 137 | 126 |
| Present Example 149 | GD-3 | GHH-5 | GEH-4 | 4.06 | 137 | 126 |
| Present Example 150 | GD-3 | GHH-5 | GEH-5 | 3.98 | 136 | 122 |

**[Table 12]**

| | Light-emitting layer | | | Operation voltage (V) | EQE (%, relative value) | LT95 (%, relative value) |
|---|---|---|---|---|---|---|
| | Dopant | Host | | | | |
| Comparative Example 4 | GD-4 | CBP | | 4.32 | 100 | 100 |
| Present Example 151 | GD-4 | GHH-1 | GEH-1 | 4.17 | 124 | 118 |
| Present Example 152 | GD-4 | GHH-1 | GEH-2 | 4.10 | 123 | 117 |
| Present Example 153 | GD-4 | GHH-1 | GEH-3 | 4.14 | 120 | 116 |
| Present Example 154 | GD-4 | GHH-1 | GEH-4 | 4.16 | 125 | 117 |
| Present Example 155 | GD-4 | GHH-1 | GEH-5 | 4.05 | 126 | 115 |
| Present Example 156 | GD-4 | GHH-2 | GEH-1 | 4.35 | 128 | 122 |
| Present Example 157 | GD-4 | GHH-2 | GEH-2 | 4.14 | 131 | 129 |
| Present Example 158 | GD-4 | GHH-2 | GEH-3 | 4.21 | 130 | 121 |
| Present Example 159 | GD-4 | GHH-2 | GEH-4 | 4.14 | 131 | 123 |
| Present Example 160 | GD-4 | GHH-2 | GEH-5 | 4.03 | 131 | 122 |
| Present Example 161 | GD-4 | GHH-3 | GEH-1 | 4.19 | 126 | 115 |
| Present Example 162 | GD-4 | GHH-3 | GEH-2 | 4.23 | 120 | 118 |
| Present Example 163 | GD-4 | GHH-3 | GEH-3 | 4.05 | 121 | 115 |
| Present Example 164 | GD-4 | GHH-3 | GEH-4 | 4.09 | 122 | 112 |
| Present Example 165 | GD-4 | GHH-3 | GEH-5 | 4.17 | 121 | 116 |

**[Table 13]**

| | Light-emitting layer | | | Operation voltage (V) | EQE (%, relative value) | LT95 (%, relative value) |
|---|---|---|---|---|---|---|
| | Dopant | Host | | | | |
| Comparative Example 4 | GD-4 | CBP | | 4.32 | 100 | 100 |
| Present Example 166 | GD-4 | GHH-4 | GEH-1 | 4.15 | 134 | 127 |
| Present Example 167 | GD-4 | GHH-4 | GEH-2 | 4.20 | 132 | 128 |
| Present Example 168 | GD-4 | GHH-4 | GEH-3 | 4.24 | 132 | 124 |
| Present Example 169 | GD-4 | GHH-4 | GEH-4 | 4.12 | 130 | 126 |
| Present Example 170 | GD-4 | GHH-4 | GEH-5 | 4.14 | 133 | 122 |
| Present Example 171 | GD-4 | GHH-5 | GEH-1 | 4.21 | 139 | 130 |
| Present Example 172 | GD-4 | GHH-5 | GEH-2 | 4.16 | 139 | 131 |
| Present Example 173 | GD-4 | GHH-5 | GEH-3 | 4.19 | 137 | 124 |
| Present Example 174 | GD-4 | GHH-5 | GEH-4 | 4.15 | 139 | 127 |
| Present Example 175 | GD-4 | GHH-5 | GEH-5 | 4.16 | 134 | 125 |

**[Table 14]**

| | Light-emitting layer | | | Operation voltage (V) | EQE (%, relative value) | LT95 (%, relative value) |
|---|---|---|---|---|---|---|
| | Dopant | Host | | | | |
| Comparative Example 5 | GD-5 | CBP | | 4.32 | 100 | 100 |
| Present Example 176 | GD-5 | GHH-1 | GEH-1 | 4.15 | 126 | 117 |
| Present Example 177 | GD-5 | GHH-1 | GEH-2 | 4.05 | 124 | 121 |
| Present Example 178 | GD-5 | GHH-1 | GEH-3 | 4.07 | 126 | 113 |
| Present Example 179 | GD-5 | GHH-1 | GEH-4 | 4.05 | 120 | 115 |
| Present Example 180 | GD-5 | GHH-1 | GEH-5 | 4.12 | 125 | 117 |
| Present Example 181 | GD-5 | GHH-2 | GEH-1 | 4.30 | 130 | 127 |
| Present Example 182 | GD-5 | GHH-2 | GEH-2 | 4.08 | 130 | 124 |
| Present Example 183 | GD-5 | GHH-2 | GEH-3 | 4.04 | 131 | 123 |
| Present Example 184 | GD-5 | GHH-2 | GEH-4 | 4.06 | 132 | 126 |
| Present Example 185 | GD-5 | GHH-2 | GEH-5 | 4.15 | 136 | 123 |
| Present Example 186 | GD-5 | GHH-3 | GEH-1 | 4.18 | 127 | 115 |
| Present Example 187 | GD-5 | GHH-3 | GEH-2 | 4.10 | 120 | 120 |
| Present Example 188 | GD-5 | GHH-3 | GEH-3 | 4.00 | 123 | 116 |
| Present Example 189 | GD-5 | GHH-3 | GEH-4 | 4.07 | 127 | 118 |
| Present Example 190 | GD-5 | GHH-3 | GEH-5 | 4.14 | 123 | 117 |

**[Table 15]**

| | Light-emitting layer | | | Operation voltage (V) | EQE (%, relative value) | LT95 (%, relative value) |
|---|---|---|---|---|---|---|
| | Dopant | Host | | | | |
| Comparative Example 5 | GD-5 | CBP | | 4.32 | 100 | 100 |
| Present Example 191 | GD-5 | GHH-4 | GEH-1 | 4.21 | 134 | 128 |
| Present Example 192 | GD-5 | GHH-4 | GEH-2 | 4.10 | 133 | 131 |
| Present Example 193 | GD-5 | GHH-4 | GEH-3 | 4.15 | 133 | 126 |
| Present Example 194 | GD-5 | GHH-4 | GEH-4 | 4.05 | 133 | 126 |
| Present Example 195 | GD-5 | GHH-4 | GEH-5 | 4.06 | 129 | 121 |
| Present Example 196 | GD-5 | GHH-5 | GEH-1 | 4.10 | 137 | 128 |
| Present Example 197 | GD-5 | GHH-5 | GEH-2 | 4.21 | 138 | 130 |
| Present Example 198 | GD-5 | GHH-5 | GEH-3 | 4.16 | 134 | 125 |
| Present Example 199 | GD-5 | GHH-5 | GEH-4 | 4.24 | 139 | 128 |
| Present Example 200 | GD-5 | GHH-5 | GEH-5 | 4.10 | 138 | 129 |

From the results of Table 1 to Table 15, the organic light-emitting diode of each of Present Examples 1 to 200, which has the organometallic compound satisfying the structure represented by the Chemical Formula 1 of the present disclosure as the dopant of the light-emitting layer, and a mixture of the compound represented by the Chemical Formula 2 and the compound represented by the Chemical Formula 3 as the host of the light-emitting layer, has lower operation voltage, and improved external quantum efficiency (EQE) and lifetime (LT95), compared to the organic light-emitting diode of each of Comparative Examples 1 to 5 in which a single material is used as the host of the light-emitting layer.

Although the embodiments of the present disclosure have been described in more detail with reference to the accompanying drawings, the present disclosure is not limited to these embodiments, and may be modified in a various manner within the scope of the technical spirit of the present disclosure. Accordingly, the embodiments as disclosed in the present disclosure are intended to describe rather than limit the technical idea of the present disclosure, and the scope of the technical idea of the present disclosure is not limited by these embodiments. Therefore, it should be understood that the embodiments described above are not restrictive but illustrative in all aspects.

## Claims

1. An organic light-emitting diode comprising:
a first electrode;
a second electrode facing the first electrode; and
an organic layer disposed between the first electrode and the second electrode, the organic layer including a light-emitting layer that includes:
a dopant material including an organometallic compound represented by Chemical Formula 1, and
a host material including a mixture including a compound represented by Chemical Formula 2 and a compound represented by Chemical Formula 3: 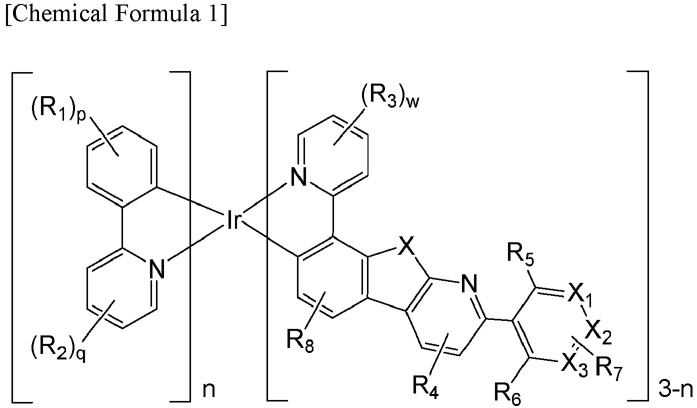 wherein in the Chemical Formula 1,
X represents one selected from the group consisting of oxygen (O), sulfur (S), and selenium (Se),
each of X₁, X₂, and X₃ independently represents nitrogen (N) or CR',
each of R₁, R₂, R₃, R₄, R₇, R₈, and R' independently represents one selected from the group consisting of hydrogen, deuterium, halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₁, R₂, R₃, R₄, R₇, R₈, and R' is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₁, R₂, R₃, R₄, R₇, R₈, and R' is optionally substituted by deuterium,
wherein each of R₅ and R₆ independently represents one selected from the group consisting of halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₅ and R₆ is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₅ and R₆ is optionally substituted by deuterium,
n is an integer from 0 to 2, and
p, q and w independently are an integer from 1 to 4, 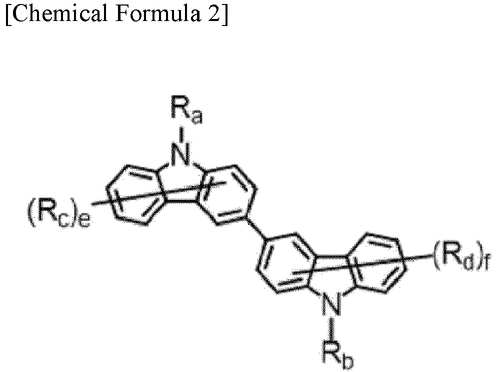 wherein in the Chemical Formula 2,
each of Rₐ and R_{b} independently represents one selected from the group consisting of a C6 to C40 monocyclic aryl group, a polycyclic aryl group, a monocyclic heteroaryl group, and a polycyclic heteroaryl group, where each of Rₐ and R_{b} is independently optionally substituted with at least one substituent selected from the group consisting of an alkyl group, an aryl group, a heteroaryl group, a cyano group, an alkylsilyl group, and an aryl silyl group,
each of R_{c} and R_{d} independently represents one selected from the group consisting of hydrogen, deuterium, halogen, a cyano group, and an alkyl group, wherein each of e and f independently represents an integer from 0 to 7, when e is 2, 3, 4, 5, 6 or 7, each R_{c} is the same as or different from each other, when f is 2, 3, 4, 5, 6 or 7, each R_{d} is the same as or different from each other, 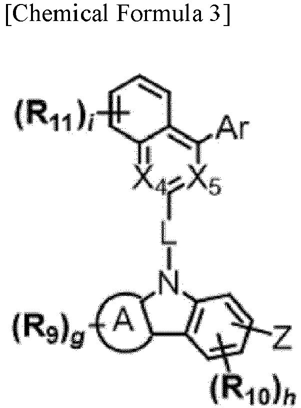 wherein in the Chemical Formula 3,
a ring A represents a monocyclic or polycyclic aryl group,
each of X₄ and X₅ independently represents N or CR₁₂;
L represents one selected from the group consisting of a single bond, a C1 to C10 alkylene group, a C6 to C30 arylene group, a C2 to C30 heteroarylene group, and a C5 to C30 cycloalkylene group,
Ar represents one selected from the group consisting of hydrogen, deuterium, halogen, a C1 to C30 alkyl group, a C6 to C30 aryl group, and a C2 to C30 heteroaryl group;
Z represents one selected from the group consisting of compounds of following structures: 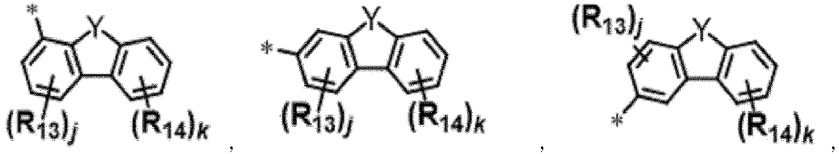 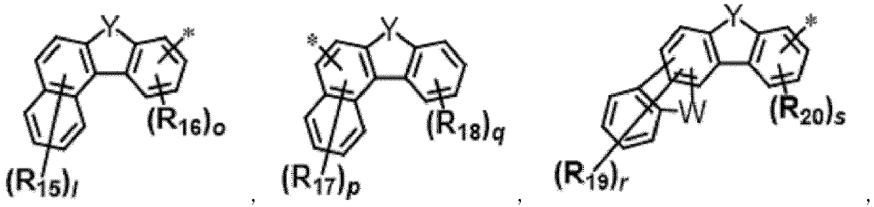 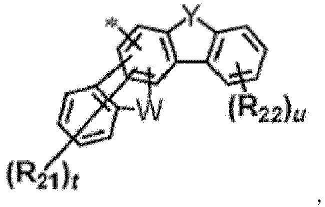
where each of Y and W independently represents one selected from the group consisting of O, S, C(R₂₃)₂, and NR₂₄,
each of R₉ to R₂₄ independently represents one selected from the group consisting of hydrogen, deuterium, halogen, hydroxyl group, a cyano group, a nitro group, an amidino group, a C1 to C10 alkyl group, a C3 to C20 cycloalkyl group, a C1 to C20 heteroalkyl group, a C7 to C20 an arylalkyl group, a C6 to C30 aryl group, and a C2 to C30 heteroaryl group,
each of i, k, q, and u independently is an integer from 1 to 4,
each of h, j, o, and s independently is an integer from 1 to 3,
each of g, and 1 independently is an integer from 1 to 6,
r is an integer from 1 to 6, and
each of p and t independently is an integer from 1 to 5.

2. An organic light-emitting diode comprising:
a first electrode;
a second electrode facing the first electrode;
a first light-emitting stack; and
a second light-emitting stack,
wherein the first and second light-emitting stacks are disposed between the first electrode and the second electrode,
wherein each of the first light-emitting stack and the second light-emitting stack includes at least one light-emitting layer including a green phosphorescent light-emitting layer including:
a dopant material including an organometallic compound represented by Chemical Formula 1, and
a host material including a mixture including a compound represented by Chemical Formula 2 and a compound represented by Chemical Formula 3: 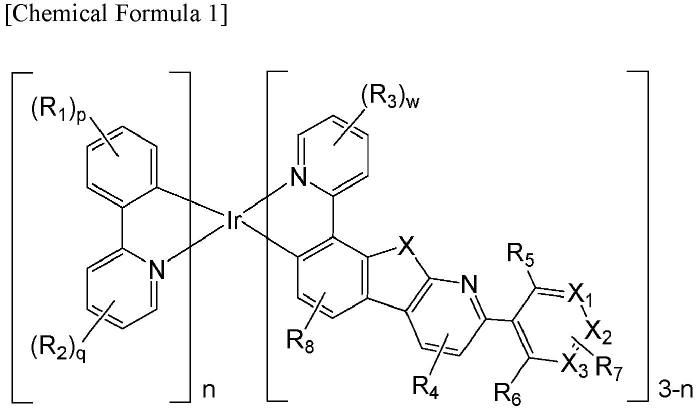 wherein in the Chemical Formula 1,
X represents one selected from the group consisting of oxygen (O), sulfur (S), and selenium (Se),
each of X₁, X₂, and X₃ independently represents nitrogen (N) or CR',
each of R₁, R₂, R₃, R₄, R₇, R₈, and R' independently represents one selected from the group consisting of hydrogen, deuterium, halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₁, R₂, R₃, R₄, R₇, R₈, and R' is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₁, R₂, R₃, R₄, R₇, R₈, and R' is optionally substituted by deuterium,
wherein each of R₅ and R₆ independently represents one selected from the group consisting of halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₅ and R₆ is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₅ and R₆ is optionally substituted by deuterium,
n is an integer from 0 to 2, and
p, q and w independently are an integer from 1 to 4, 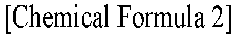 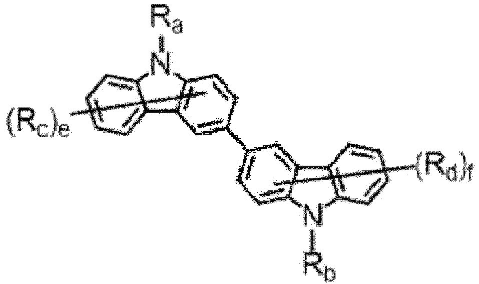 wherein in the Chemical Formula 2,
each of Rₐ and R_{b} independently represents one selected from the group consisting of a C6 to C40 monocyclic aryl group, a polycyclic aryl group, a monocyclic heteroaryl group, and a polycyclic heteroaryl group, wherein each of Rₐ and R_{b} is independently optionally substituted with at least one substituent selected from the group consisting of an alkyl group, an aryl group, a heteroaryl group, a cyano group, an alkylsilyl group, and an aryl silyl group,
each of R_{c} and R_{d} independently represents one selected from the group consisting of hydrogen, deuterium, halogen, a cyano group, and an alkyl group, wherein each of e and f independently represents an integer from 0 to 7, when e is 2, 3, 4, 5, 6 or 7, each R_{c} is the same as or different from each other, when f is 2, 3, 4, 5, 6 or 7, each R_{d} is the same as or different from each other, 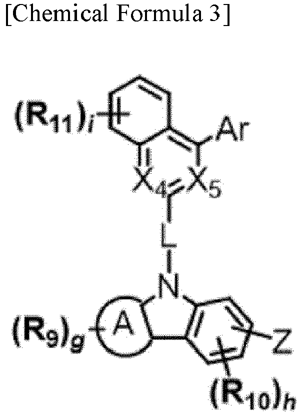 wherein in the Chemical Formula 3,
a ring A represents a monocyclic or polycyclic aryl group,
each of X₄ and X₅ independently represents N or CR₁₂;
L represents one selected from the group consisting of a single bond, a C1 to C10 alkylene group, a C6 to C30 arylene group, a C2 to C30 heteroarylene group, and a C5 to C30 cycloalkylene group,
Ar represents one selected from the group consisting of hydrogen, deuterium, halogen, a C1 to C30 alkyl group, a C6 to C30 aryl group, and a C2 to C30 heteroaryl group;
Z represents one selected from the group consisting of compounds of following structures: 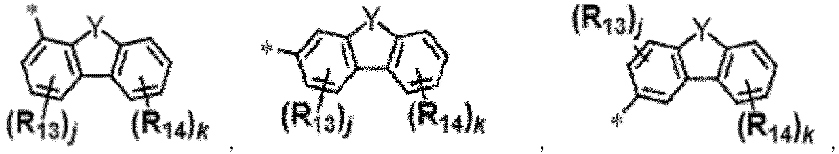 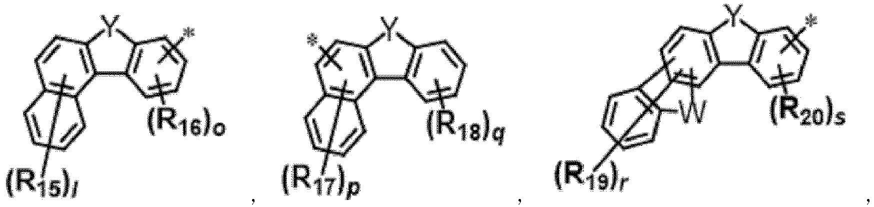 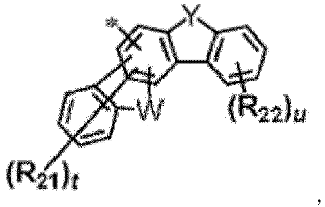
where each of Y and W independently represents one selected from the group consisting of O, S, C(R₂₃)₂, and NR₂₄,
each of R₉ to R₂₄ independently represents one selected from the group consisting of hydrogen, deuterium, halogen, hydroxyl group, a cyano group, a nitro group, an amidino group, a C1 to C10 alkyl group, a C3 to C20 cycloalkyl group, a C1 to C20 heteroalkyl group, a C7 to C20 arylalkyl group, a C6 to C30 aryl group, and a C2 to C30 heteroaryl group,
each of i, k, q, and u independently is an integer from 1 to 4,
each of h, j, o, and s independently is an integer from 1 to 3,
each of g, and 1 independently is an integer from 1 to 6,
r is an integer from 1 to 6, and
each of p and t independently is an integer from 1 to 5.

3. An organic light-emitting diode comprising:
a first electrode;
a second electrode facing the first electrode; and
a first light-emitting stack;
a second light-emitting stack; and
a third light-emitting stack, wherein the first, second, and third light-emitting stacks are disposed between the first electrode and the second electrode,
wherein each of the first light-emitting stack, the second light-emitting stack, and the third light-emitting stack includes at least one light-emitting layer that includes a green phosphorescent light-emitting layer that includes:
a dopant material including an organometallic compound represented by Chemical Formula 1, and
a host material including a mixture including a compound represented by Chemical Formula 2 and a compound represented by Chemical Formula 3: 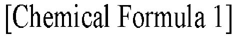 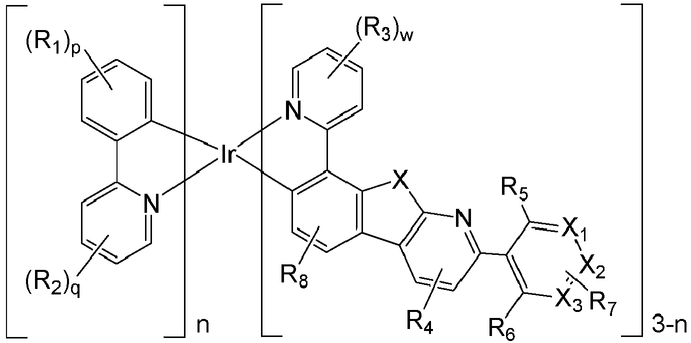 wherein in the Chemical Formula 1,
X represents one selected from the group consisting of oxygen (O), sulfur (S), and selenium (Se),
each of X₁, X₂, and X₃ independently represents nitrogen (N) or CR',
each of R₁, R₂, R₃, R₄, R₇, R₈, and R' independently represents one selected from the group consisting of hydrogen, deuterium, halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₁, R₂, R₃, R₄, R₇, R₈, and R' is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₁, R₂, R₃, R₄, R₇, R₈, and R' is optionally substituted by deuterium,
wherein each of R₅ and R₆ independently represents one selected from the group consisting of halogen, an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, and a phosphino group,
wherein when at least one of R₅ and R₆ is an alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, or a phosphino group, at least one hydrogen of the at least one of R₅ and R₆ is optionally substituted by deuterium,
n is an integer from 0 to 2, and
p, q and w independently are an integer from 1 to 4, 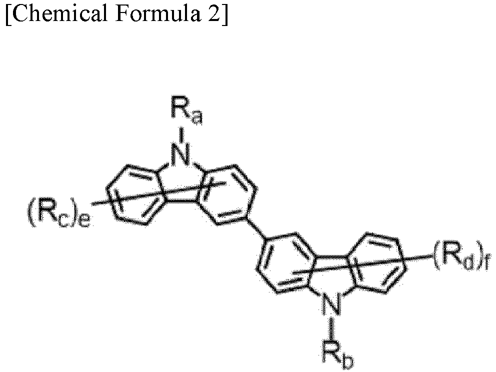 wherein in the Chemical Formula 2,
each of Rₐ and R_{b} independently represents one selected from the group consisting of a C6 to C40 monocyclic aryl group, a polycyclic aryl group, a monocyclic heteroaryl group, and a polycyclic heteroaryl group, wherein each of Rₐ and R_{b} is independently optionally substituted with at least one substituent selected from the group consisting of an alkyl group, an aryl group, a heteroaryl group, a cyano group, an alkylsilyl group, and an aryl silyl group,
each of R_{c} and R_{d} independently represents one selected from the group consisting of hydrogen, deuterium, halogen, a cyano group, and an alkyl group, wherein each of e and f independently represents an integer from 0 to 7, when e is 2, 3, 4, 5, 6 or 7, each R_{c} is the same as or different from each other, when f is 2, 3, 4, 5, 6 or 7, each R_{d} is the same as or different from each other, 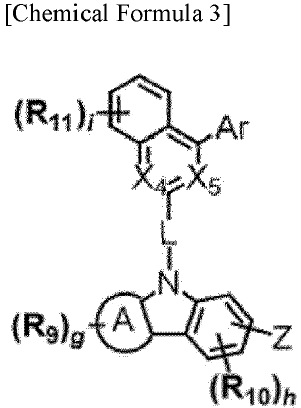 wherein in the Chemical Formula 3,
a ring A represents a monocyclic or polycyclic aryl group,
each of X₄ and X₅ independently represents N or CR₁₂;
L represents one selected from the group consisting of a single bond, a C1 to C10 alkylene group, a C6 to C30 arylene group, a C2 to C30 heteroarylene group, and a C5 to C30 cycloalkylene group,
Ar represents one selected from the group consisting of hydrogen, deuterium, halogen, a C1 to C30 alkyl group, a C6 to C30 aryl group, and a C2 to C30 heteroaryl group;
Z represents one selected from the group consisting of compounds of following structures: 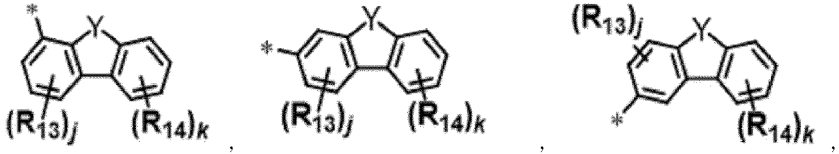 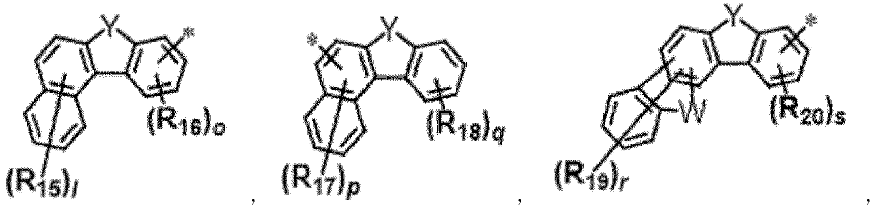 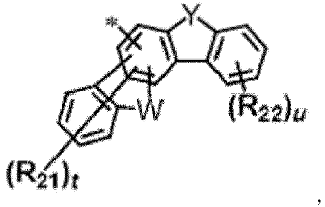
where each of Y and W independently represents one selected from the group consisting of O, S, C(R₂₃)₂, and NR₂₄,
each of R₉ to R₂₄ independently represents one selected from the group consisting of hydrogen, deuterium, halogen, hydroxyl group, a cyano group, a nitro group, an amidino group, a C1 to C10 alkyl group, a C3 to C20 cycloalkyl group, a C1 to C20 heteroalkyl group, a C7 to C20 arylalkyl group, a C6 to C30 aryl group, and a C2 to C30 heteroaryl group,
each of i, k, q, and u independently is an integer from 1 to 4,
each of h, j, o, and s independently is an integer from 1 to 3,
each of g, and 1 independently is an integer from 1 to 6,
r is an integer from 1 to 6, and
each of p and t independently is an integer from 1 to 5.

4. The organic light-emitting diode of any preceding claim, wherein in the Chemical Formula 1, n is 2.

5. The organic light-emitting diode of any preceding claim, wherein X in the Chemical Formula 1 is oxygen (O).

6. The organic light-emitting diode of any of claims 1 to 3, wherein the organometallic compound represented by the Chemical Formula 1 includes one selected from the group consisting of compound GD-1 to compound GD-10:

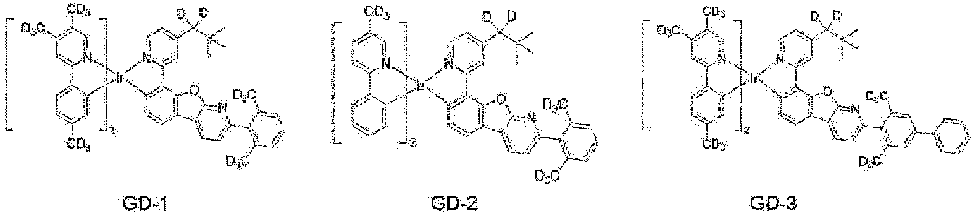

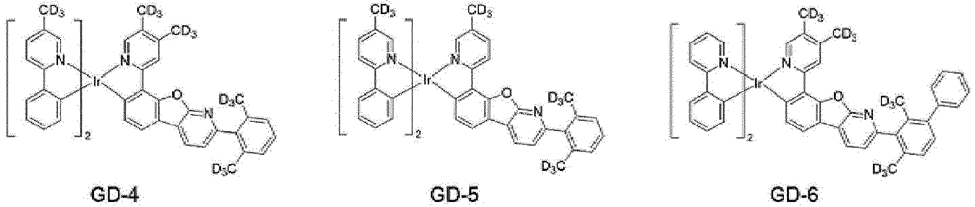

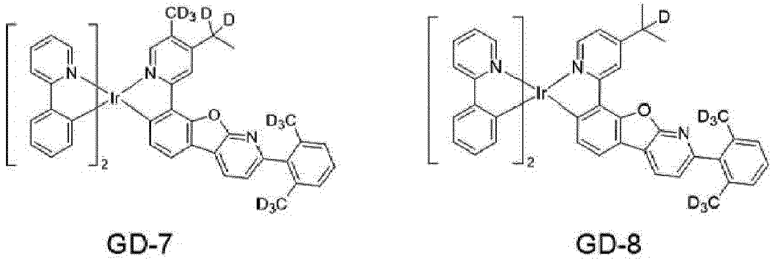

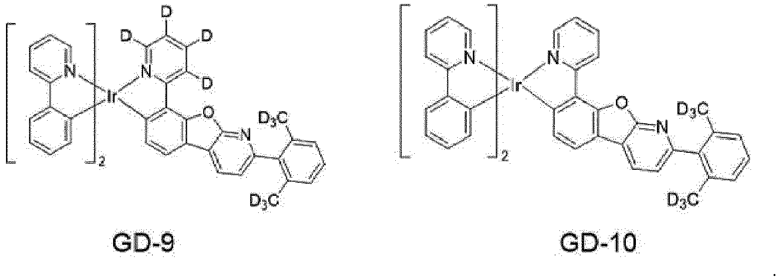

7. The organic light-emitting diode of any preceding claim, wherein each of Rₐ and R_{b} in the Chemical Formula 2 independently represents one selected from the group consisting of a phenyl group, a naphthyl group, an anthryl group, a chrysenyl group, a pyrenyl group, a phenanthryl group, a triphenylenyl group, a fluorenyl group, and a 9,9'-spirofluorenyl group.

8. The organic light-emitting diode of any of claims 1 to 6, wherein the compound represented by the Chemical Formula 2 includes one selected from the group consisting of compound GHH-1 to compound GHH-20:

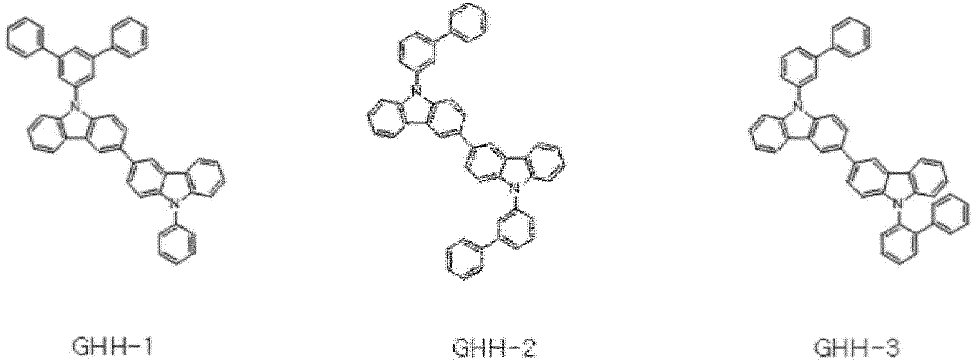

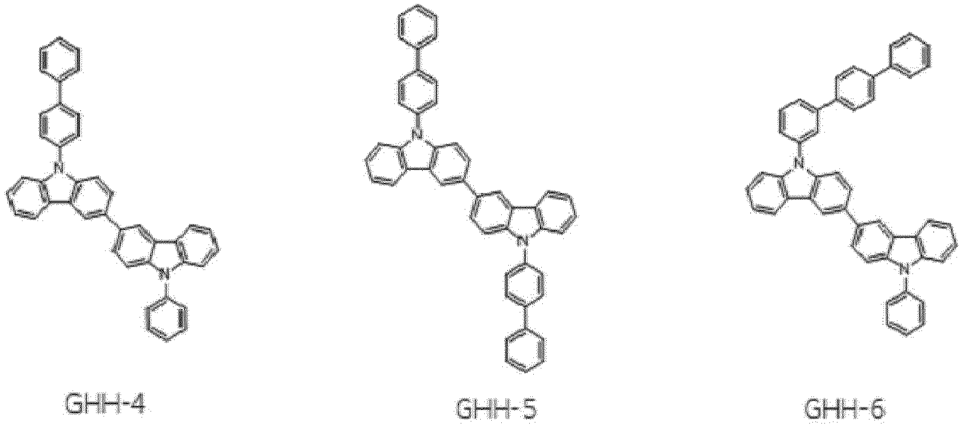

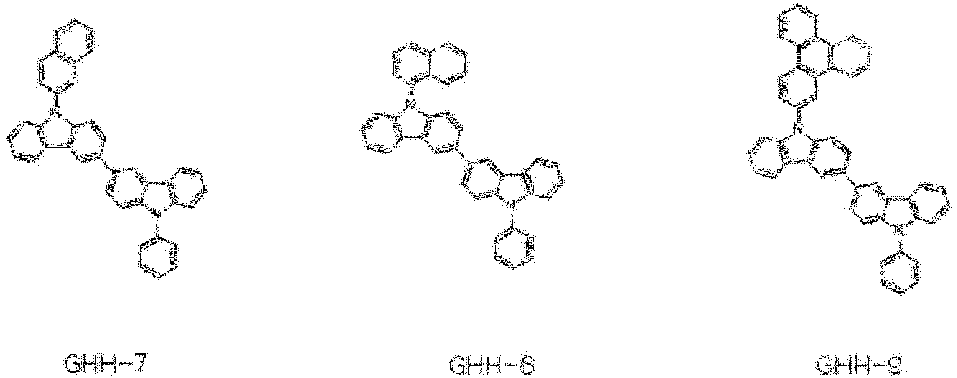

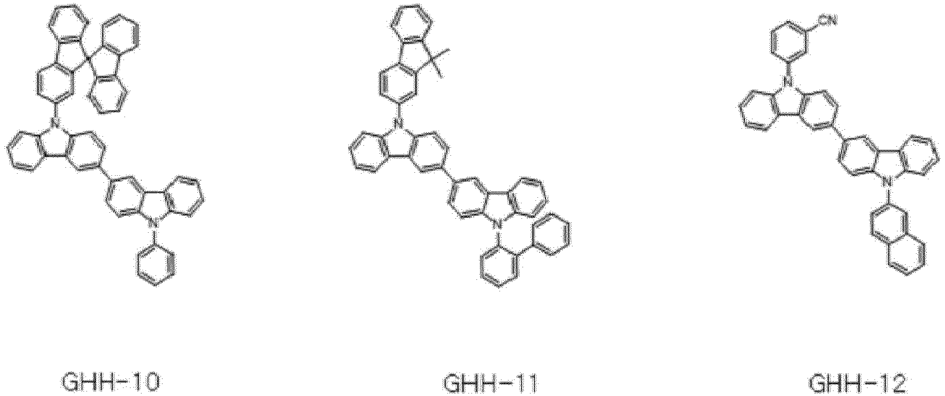

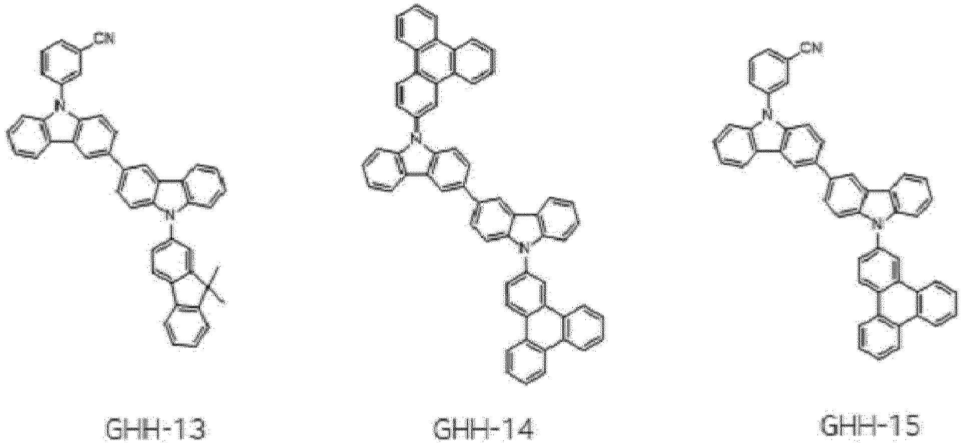

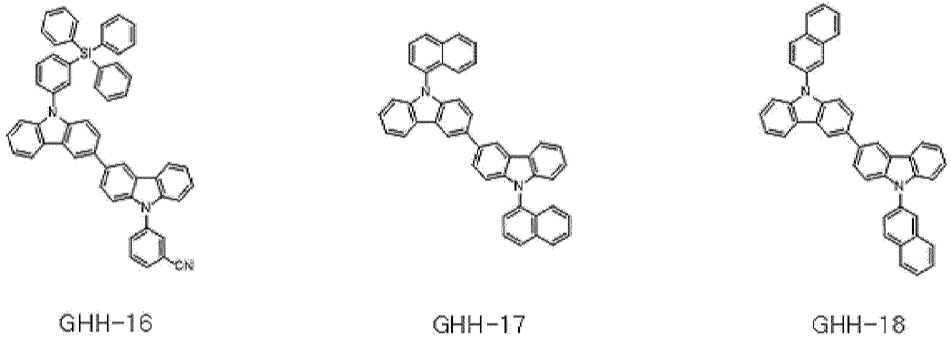

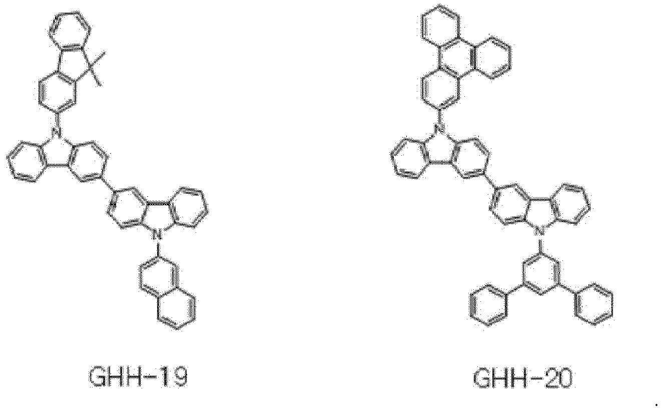

9. The organic light-emitting diode of any preceding claim, wherein each of X₄ and X₅ in the Chemical Formula 3 independently represents N.

10. The organic light-emitting diode of any preceding claim, wherein L in the Chemical Formula 3 represents a single bond or a phenyl group.

11. The organic light-emitting diode of any preceding claim, wherein each of R₉ to R₂₄ in the Chemical Formula 3 independently represents one selected from the group consisting of hydrogen, deuterium, a C1 to C10 alkyl group, a C7 to C20 arylalkyl group, a C6 to C30 aryl group, and a C2 to C30 heteroaryl group.

12. The organic light-emitting diode of any of claims 1 to 8, wherein the compound represented by the Chemical Formula 3 includes one selected from the group consisting of compound GEH-1 to compound GEH-20:

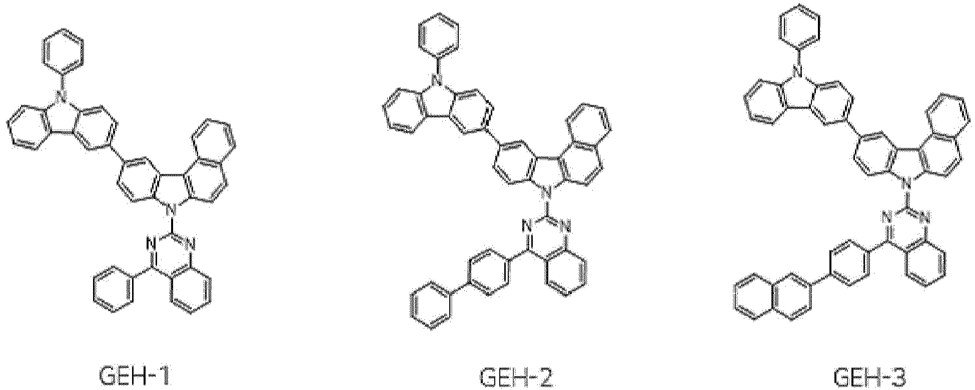

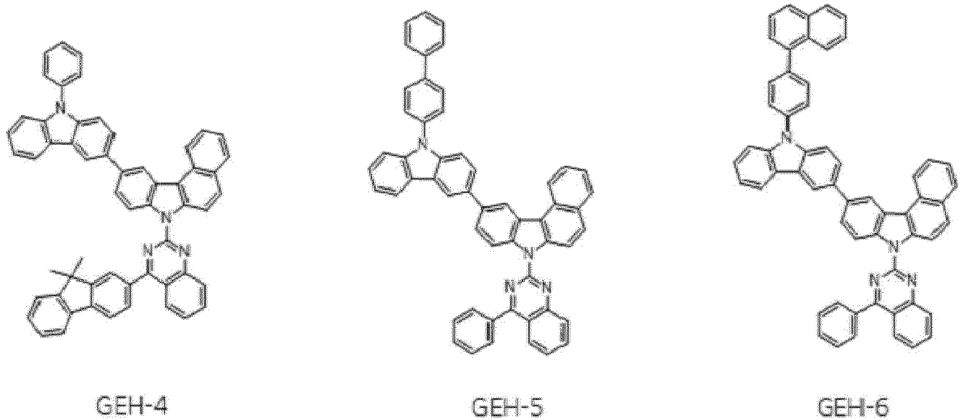

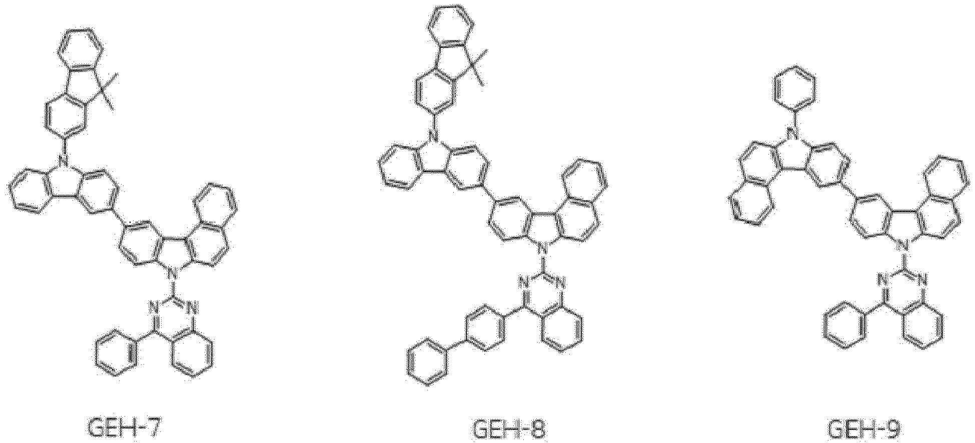

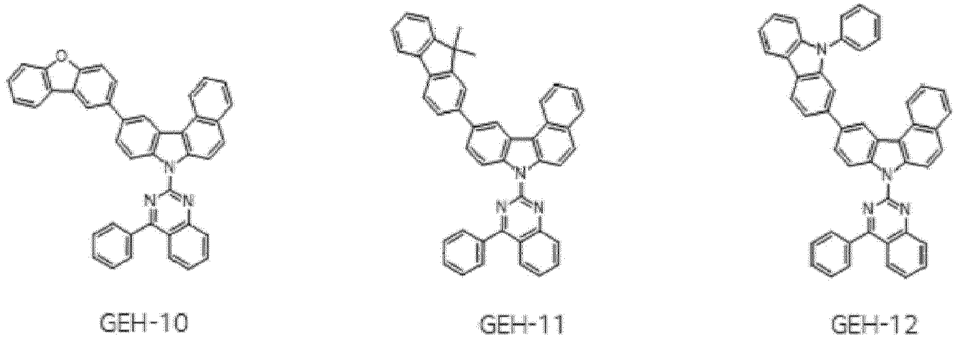

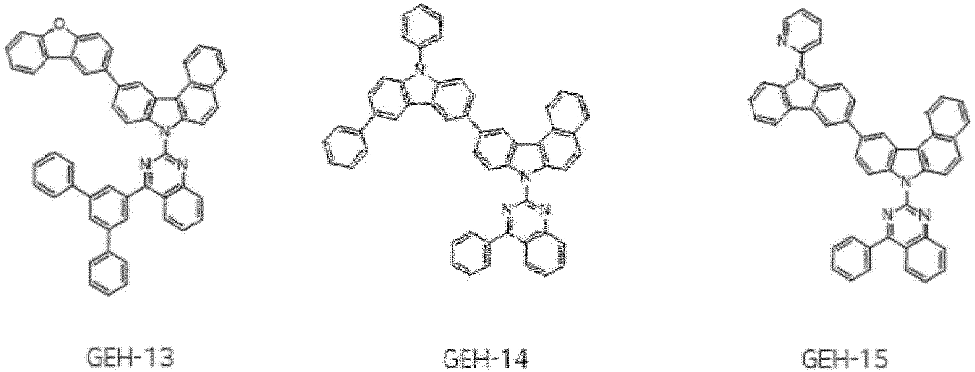

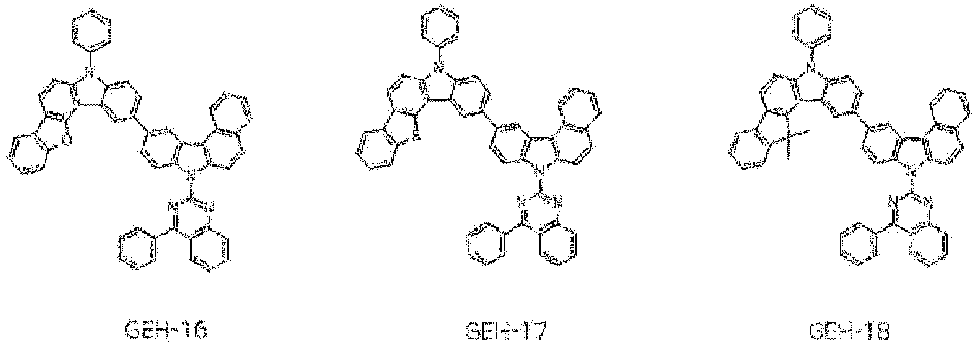

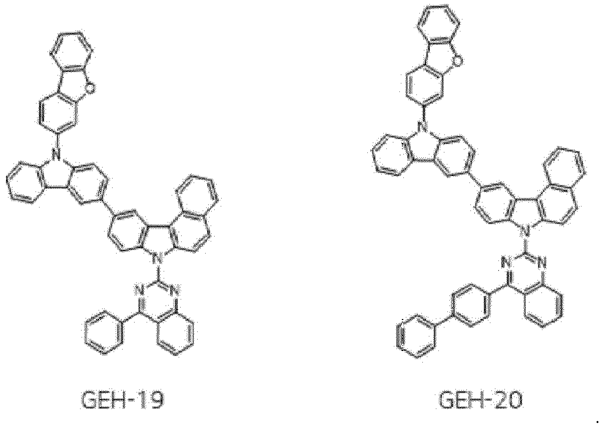

13. The organic light-emitting diode of any preceding claim, wherein the organic layer further includes at least one selected from the group consisting of a hole injection layer, a hole transport layer, an electron transport layer, and an electron injection layer.

14. An organic light-emitting display device comprising:
a substrate;
a driving element disposed on the substrate; and
an organic light-emitting diode disposed on the substrate and connected to the driving element, wherein the organic light-emitting diode includes the organic light-emitting diode of one of claims 1 to 13.
